(19) Europäisches Patentamt
European Patent Office
Office européen des brevets

(11) **EP 2 352 179 A2**

(12) **EUROPEAN PATENT APPLICATION**

(43) Date of publication:
**03.08.2011 Bulletin 2011/31**

(51) Int Cl.:
***H01L 31/052*** (2006.01)  ***C09J 9/00*** (2006.01)
***H01L 31/18*** (2006.01)

(21) Application number: **11152855.0**

(22) Date of filing: **01.02.2011**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **02.02.2010 US 300482 P**

(71) Applicant: **T.O.U. Millennium Electric Ltd.**
**43650 Raanana (IL)**

(72) Inventor: **Elazari, Ami**
**69364, Tel-Aviv (IL)**

(74) Representative: **Fichter, Robert Arno**
**Dennemeyer & Associates S.A.**
**55, rue des Bruyères**
**1274 Howald (LU)**

(54) **Solar panel with cooling arrangement**

(57) A solar panel comprises an array (12) of solar cells, a cooling arrangement (14), and thermal glue (16) which thermally connects the solar cells to the cooling fins. The whole may be enclosed within a frame (20) and backing structure (18). The thermal glue (16) may be a silicon cream, or a mixture of silicon cream and metallic particles.

**EP 2 352 179 A2**

**Description**

<u>FIELD AND BACKGROUND OF THE INVENTION</u>

The present invention relates in general to the use of solar energy and more particularly to conversion of solar energy to electrical and thermal energy using photovoltaic cells in what is known as a multi-solar panel. More particularly but not exclusively the present invention relates to thermal efficiency issues with the solar cells and solutions to these issues within the confines of the Photovoltaic solar panel.

The conversion of solar energy to thermal or electrical energy may use systems such as photovoltaic arrays, passive absorbers of solar energy, solar furnaces etc.. These systems have also been proposed for simultaneously converting solar energy to thermal and electrical energy. However, these systems employ apparatus which are complicated to fabricate, such as sealed solar collector enclosures or plate thermal collectors mounted under the solar cells.

Systems that produce both electrical and solar energy simultaneously are referred to as multi-solar systems.

Today, with the massive development of the solar energy market, there is still a need for a simple, reliable and inexpensive system for converting solar energy to thermal and electrical energy.

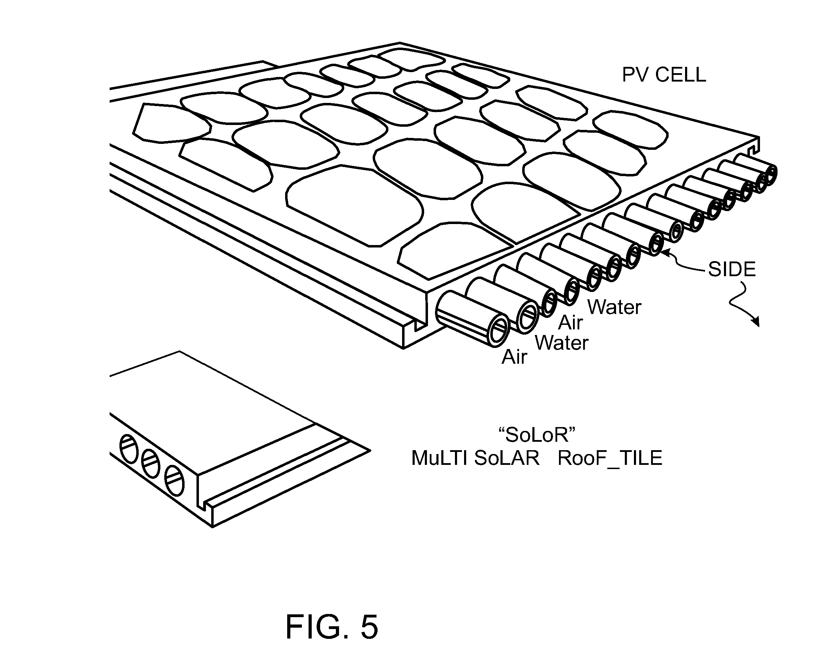

PV/T (photovoltaic thermal) domestic systems are able to put the heat arising in the system to good use. Various types are available, for example with cover or without, water or air type, etc. Fig. 5 illustrates a prior proposal by the present applicants which use both water and air for cooling of the PV panels. The created energy may be used for the domestic hot water generation (DHW) and the room heating of a building and also for industrial use and generating electricity from heat using co-generation.. The cooling of the PV panels enables the electrical output of the system to be improved. Additionally the panel can be integrated into the facade or the roof of the building.

The proposal shown in Fig. 5 is a co-generation solar device that makes it possible to convert solar energy into thermal energy and electric energy at the same time using a single integrated system. The system is a solar energy harvesting device, formed by the coupling of:

1. PV modules capable of collecting the visible spectrum of the light; these can be modules based on any commercial technology.

2. A collector, a solar PV/Thermal system that collects the visible & infrared sides of the spectrum, cools the PV cells that generate electricity and makes the heat available for the thermal energy control of the building. The photovoltaic (PV)/Thermal collector can be used to provide façade rooftile panels which in turn provide a building façade that behaves as a living skin surrounding the building, providing water/air flows, capturing heat, storing in an insulated tank and making the heat available for heat control of the living environment, while at the same time the PV cell cooled by the water flow generates higher electricity for domestic use.

3. Structural building elements such as panels and tiles. The system is designed to be strong enough to fulfill structural roles, being for instance the covering roof or the walls of a building.

In the collectors, a domestic hot water (DHW) flat plate grille panel may be exposed to the highest solar radiation, placed on the back side of PV modules and may be integrated on the free surface of the roof of the buildings. The panels may be fully integrated with any necessary electronic power components.

The system comprises the integration of the PV Panel & cells with a solar cooling device, that makes it possible to exploit solar energy to produce electricity and heat at the same time, using a single device. The water flows in a pipe within the grille on the back of the PV panel to cool the PV cells and thus increase their relative efficiency and at the same time collect the heat for domestic (or for that matter industrial) use.

Additionally, the system provides another advantage. By coupling the two devices, the PV system and the Thermal system, it reduces the operational temperature of the PV cell thus increasing the electrical efficiency and operational life, particularly in relation to the thermal stress of the mechanical structure of the cells. In fact, the system makes possible the circulation of appropriate water and air beyond the PV cells, thus improving the efficiency of the cell and collecting heat just as a traditional solar-thermal element.

Nevertheless heat transfer issues arise with the structures described above. These are addressed by the present embodiments.

<u>SUMMARY OF THE INVENTION</u>

A thermal glue may be used to attach solar cells to a thermal cooling arrangement.

According to one aspect of the present invention there is provided a solar panel comprising:

an array of solar cells;
a cooling arrangement comprising cooling fins; and

thermal glue thermally connecting the solar cells to the cooling fins.

In an embodiment, the thermal glue comprises silicon cream.

In an embodiment, the thermal glue contains metallic particles.

In an embodiment, the metallic particles comprise zinc powder.

In an embodiment, the metallic particles comprise zinc dust.

In an embodiment, the metallic particles comprise copper filings.

In an embodiment, the thermal glue provides thermal equilibrium between the cooling fins and the solar cells irrespective of inexact alignment between the cooling fins and the solar cells.

An embodiment may further include a backing structure, for pressing the cooling arrangement against the thermal glue.

According to a second aspect of the present invention there is provided a composition comprising a silicon cream and metallic particles mixed therein.

In an embodiment, the metallic particles comprise zinc.

In an embodiment, the metallic particles comprise zinc powder.

In an embodiment, the metallic particles comprise zinc dust.

In an embodiment, the metallic particles comprise copper.

In an embodiment, the metallic particles comprise copper filings.

In an embodiment, the metallic particles comprise between 10% and 50% by weight of the composition.

In an embodiment, the metallic particles comprise substantially 30% by weight of the composition.

In an embodiment, the substance may havie a thermal conductivity of at least 0.9, and preferably 0.99.

According to a third aspect of the present invention there is provided a method of manufacturing a solar panel comprising:

providing an array of solar cells;
providing a cooling arrangement; and
attaching the cooling arrangement to the solar cells using thermal glue.

An embodiment may comprise additional steps of:

providing a PV frame;
fixing a backing behind the frame to press the cooling arrangement against the thermal glue and the array of solar cells.

In an embodiment, the cooling arrangement comprises a water or liquid cooling grill comprising fins for setting in thermal equilibrium with solar cells of the array, surfaces of the grill towards the solar cells being smeared with the thermal glue.

An embodiment may comprise using aluminum support structures to tighten the cooling arrangement to the backing.

An embodiment may involve covering the cooling structure with an isolation polymer.

Unless otherwise defined, all technical and scientific terms used herein have the same meaning as commonly understood by one of ordinary skill in the art to which this invention belongs. The materials, methods, and examples provided herein are illustrative only and not intended to be limiting.

The word "exemplary" is used herein to mean "serving as an example, instance or illustration". Any embodiment described as "exemplary" is not necessarily to be construed as preferred or advantageous over other embodiments and/or to exclude the incorporation of features from other embodiments.

The word "optionally" is used herein to mean "is provided in some embodiments and not provided in other embodiments". Any particular embodiment of the invention may include a plurality of "optional" features unless such features conflict.

BRIEF DESCRIPTION OF THE DRAWINGS

The invention is herein described, by way of example only, with reference to the accompanying drawings. With specific reference now to the drawings in detail, it is stressed that the particulars shown are by way of example and for purposes of illustrative discussion of the preferred embodiments of the present invention only, and are presented in order to provide what is believed to be the most useful and readily understood description of the principles and conceptual aspects of the invention. In this regard, no attempt is made to show structural details of the invention in more detail than is necessary for a fundamental understanding of the invention, the description taken with the drawings making apparent to those skilled in the art how the several forms of the invention may be embodied in practice.

In the drawings:

Fig. 1 is a simplified diagram illustrating a first device according to the present embodiments in which an array of solar panel/cells is thermally connected to a cooling arrangement;
Fig. 2 is a simplified diagram showing the device of Fig. 1 held together with backing and a frame;
Fig. 3 illustrates a substance which can be used as a thermal glue for the embodiment of Fig. 1;
Fig. 4 illustrates a process of assembling or manufacturing a solar panel according to the present embodiments;
Fig. 5 illustrates a prior proposal of a solar panel to which the present embodiments may be applied;
Fig. 6 is a graph showing temperature characteristics of solar cells, an issue addressed by the present embodiments;
Fig. 7 is a simplified graph showing a negative coefficient of output voltage to temperature in solar cells;
Figs. 8 —12 are simplified diagrams illustrating modeling of heat transfer in a first scenario relating to embodiments of the present invention; and
Figs. 13 — 20 are simplified diagrams illustrating modeling of heat transfer in a second scenario relating to embodiments of the present invention.

DESCRIPTION OF THE PREFERRED EMBODIMENTS

The present embodiments relate in general to the use of solar energy and more particularly to conversion of solar energy to electrical and thermal energy. More particularly but not exclusively the present invention relates to thermal efficiency issues with the solar cells and solutions to these issues within the confines of the solar panel.

A solar panel comprises an array of solar cells, a cooling arrangement, and thermal glue which thermally connects the solar cells to the cooling fins. The whole may be enclosed within the existing PV frame and backing. The thermal glue may be a silicon cream, or a mixture of silicon cream and metallic particles.

The principles and operation of an apparatus and method according to the present invention may be better understood with reference to the drawings and accompanying description.

Before explaining at least one embodiment of the invention in detail, it is to be understood that the invention is not limited in its application to the details of construction and the arrangement of the components set forth in the following description or illustrated in the drawings. The invention is capable of other embodiments or of being practiced or carried out in various ways. Also, it is to be understood that the phraseology and terminology employed herein is for the purpose of description and should not be regarded as limiting.

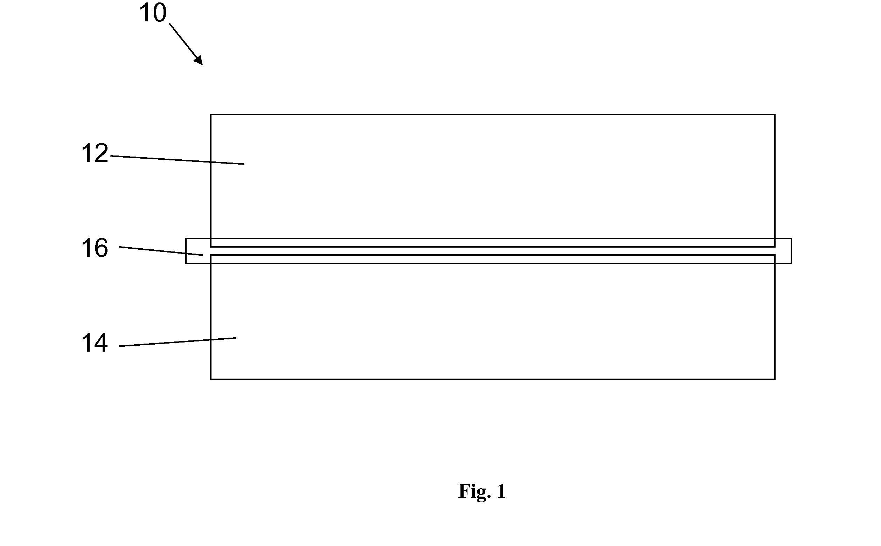

Reference is now made to Fig. 1 which illustrates a solar panel 10 according to a first embodiment of the present invention. The panel comprises an array 12 of solar cells, a cooling arrangement in the form of a grill 14, and thermal glue 16 which serves to thermally connect the solar cells to the cooling fins.

The thermal glue may comprise or consist of silicon cream, a substance which has to date been used for attaching heat sinks to transistors but has not been used in solar panels. Instead in solar panels the need to conduct heat away from the solar cells in order to maintain their efficiency is less recognized, and has usually been fulfilled by mechanical connections.

Thermal glue, particularly one based on silicon cream, is much better than a mechanical connection for providing thermal equilibrium.

In one embodiment, the thermal glue contains metallic particles. The metallic particles may be chosen for their conductivity of heat and provide a thickening agent for the silicon. It will be appreciated that the quantities of silicon cream used in a solar panel are vastly greater than those used in fitting heat sinks to transistors and thus the thickening agent is useful also to reduce cost.

Suitable metallic particles include zinc powder and copper filings.

The cooling arrangement may include cooling fins. The cooling fins may usefully extend into water pipes or air tubes to use water or air or both as a cooling fluid. The warmed air or water may then be used.

The thermal glue provides thermal equilibrium between the cooling fins and the solar cells irrespective of exact or inexact alignment between the cooling fins and the solar cells, thus making construction easier.

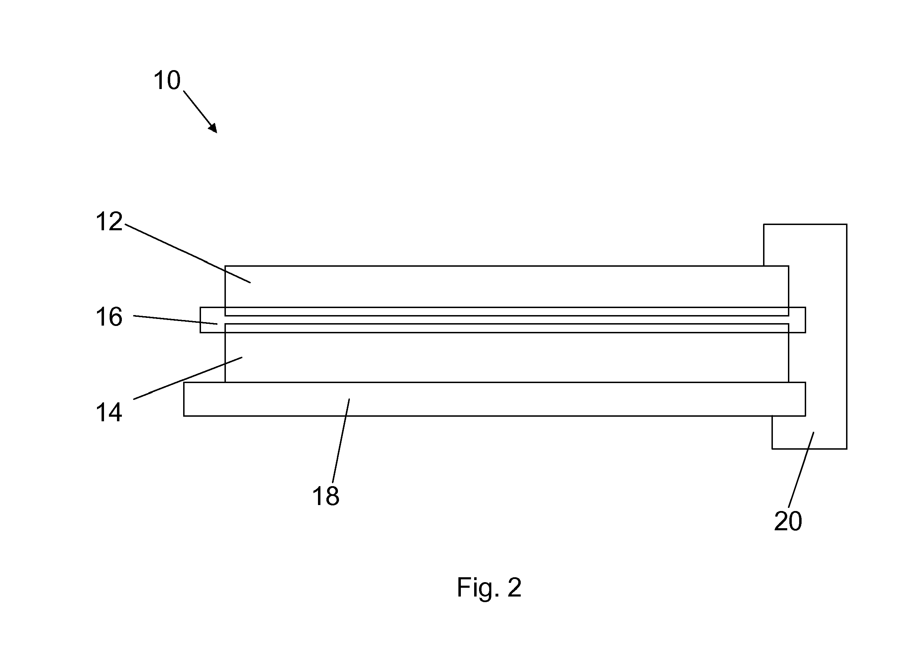

Referring now to Fig. 2, a backing structure 18, is held in place by frame 20 of which only the right hand side is shown for clarity. The backing is pressed against the cooling arrangement 14 and in turn presses the cooling arrangement against the thermal glue 16 and the solar array 12 in order to increase heat conductivity.

Silicon cream remains soft and does not dry, so the structure of Fig. 2 can easily be dismantled for servicing.

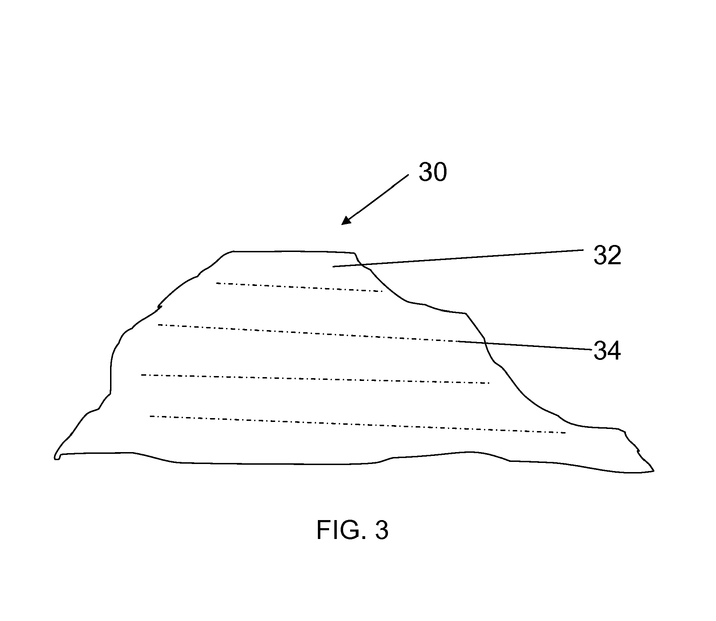

Reference is now made to Fig. 3, which illustrates composition that may be used for providing the thermal glue. A quantity 30 is shown of the composition which can be used as thermal glue for spreading between the array of solar cells 12 and the cooling arrangement 14. The quantity of thermal glue comprises a silicon cream matrix 32 containing metallic particles 34 indicated by dashed lines. The metallic particles may be zinc powder, or copper filings, as discussed above.

The metallic particles may comprise between 10 and 50% by weight of the composition and more particularly up to 30% by weight of the thermal glue.

Alternatively, the metallic particles may comprise between 10 and 50% by volume of the composition and more particularly up to 30% by volume of the thermal glue. The composition may be characterized by a thermal conductivity in excess of 0.9 and more particularly by a thermal conductivity in excess of 0.99.

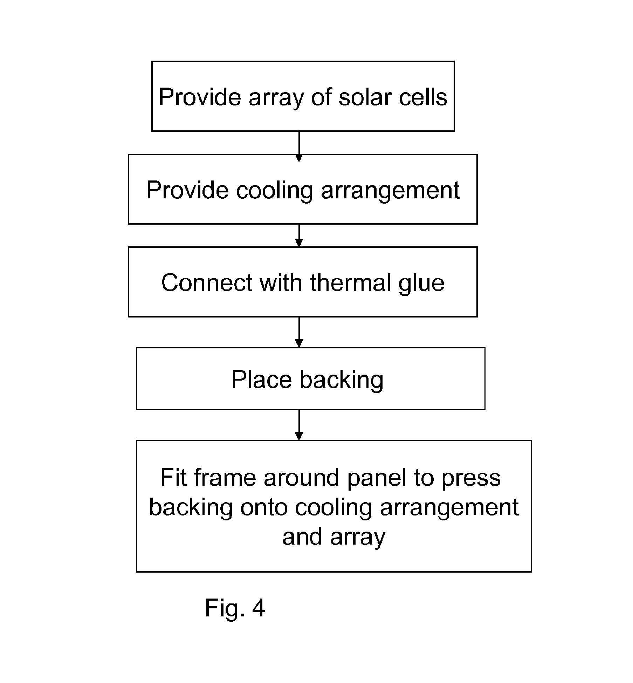

Reference is now made to Fig. 4, which is a flow chart illustrating a method of manufacturing a solar panel. The method comprises providing an array of solar cells, providing a cooling arrangement, and attaching the cooling arrangement to the solar cells using thermal glue.

A frame may be provided to fit a backing behind the cooling arrangement and press the cooling arrangement against the thermal glue and the array of solar cells.

The embodiments are now considered in greater detail.

In use, photovoltaic cells get hot ⎯ due to exposure to the sun. Even at the design temperature the cells are only 14% efficient, so the remaining energy simply adds heat.

The proposal of Fig. 5 uses pipes to cool the cell. Water gets heated so that not only is cell more efficient because it is kept at its design temperature, but free hot water is available as a by-product.

As explained above, the present embodiments comprise gluing the cooling fins to the cells using thermal glue, to more effectively receive thermal energy and cool the cells.

One may take a standard photovoltaic panel, say a collector for producing domestic hot water. The collector has a typical thickness of 8-10cms and it is very heavy in a full structure of the collector, place thermal glue on the cooling fins and then add photovoltaic cells within the structure.

However the present embodiments may provide a reduction in the thickness to 4 or 5 cms. Instead of using the entire platform of the DHW panel, one may extract the cooling arrangement, typically a grille of cooling fins. Then one may spread the thermal glue, insert the grill, and add a backing to fit the arrangement within the PV panel frame. An achievement may be attained in terms of better heat conductivity, and in any event the panel without the platform is lighter, around half the weight, and may typically weight 23Kg in place of 40Kg. The result has improved architectural aesthetics within a normal PV look. Installation becomes easier due to the reduced bulk and weight, and the result is a BIPV Building integrated PV.

In the improvement, the photovoltaic cells may form a continuous layer over the grille.

The thermal glue may be special silicon cream, which is 99% thermally conductive. Conductivity may be improved because in general the copper fins will not always lie exactly on the cells. In the past great effort was put into attempting exact alignment, but this was rarely achieved in practice. Efficiency requires thermal equilibrium between the copper and the water system, and the silicon cream allows such thermal equilibrium to be approached without needing exacting alignments. Silicon cream has been used in the known art for attaching heat sinks. Zinc powder may be added to the thermal glue, to make it thicker and help the heat transfer. Copper filings are an alternative. A suitable proportion is 30% zinc powder.

Beams on the back of an aluminium backing may serve to push the backing onto the grille, and close the grille onto the cells against the frame for a better thermal fit. Note the silicon cream remains as cream. Each beam may have a set of screws to fix the beam onto the grill or the frame. Aluminium omega elements may also be used.

The result is a final structure which is cheaper and less massive than the prior art.

The structure may include water tubes and also there is an option for air tubes. Cool air may be added at one end to improves overall cooling, and provide exhaust for heating.

If units are placed on the slope of a roof, hot air may enter the house in winter, but in summer the same pipes can help to suck out the hot air from the roof of the house, driven by convection currents.

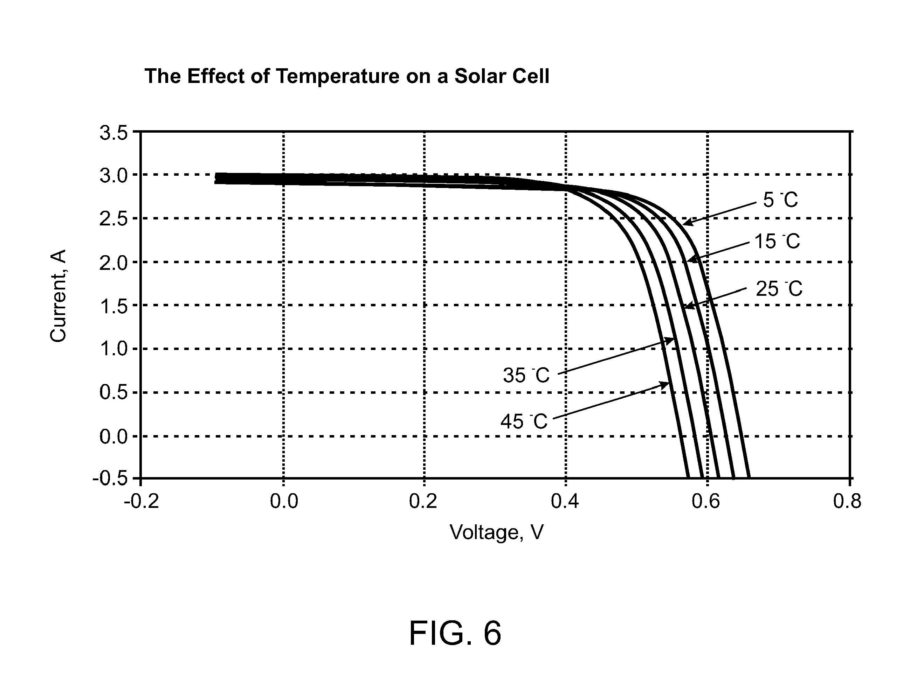

Reference is now made to Fig. 6, which is a graph illustrating the effect of temperature on solar cells. *In full sun,* the module temperature can increase to 80-90˚C. Normally, a quality module has a temperature coefficient of about -2.5V/˚C/cell. At 70˚C a 36 cell module should be able to charge the battery sufficiently. Because a protection diode is connected in series with the module in most systems, the voltage drop across this diode should also be taken into account. The I/V curve of a single cell at different temperatures, shows how the output voltage declines with the temperature. The temperature coefficient increases with a decrease in module quality. At 25˚C (STC) a 36 cell module may have an open circuit voltage of 21.96V. At 70˚C this will be 17.91V. In India, the temperature coefficient of some (locally manufactured) modules was so high, that it was not possible in some situations to charge the battery up to HVDF point. When the open circuit voltage Voc of a single cell drops to 0.4V per degree at 70˚C, the total module will give only 14.4V. When the blocking diode is also considered, the actual maximum charging voltage is 14.0V. Because the battery is never fully charged, this contributes to a decrease in the lifetime of the battery. The same may apply to grid connected inverters ⎯the voltage drop can reduce the inverter low input voltage at high temperatures.

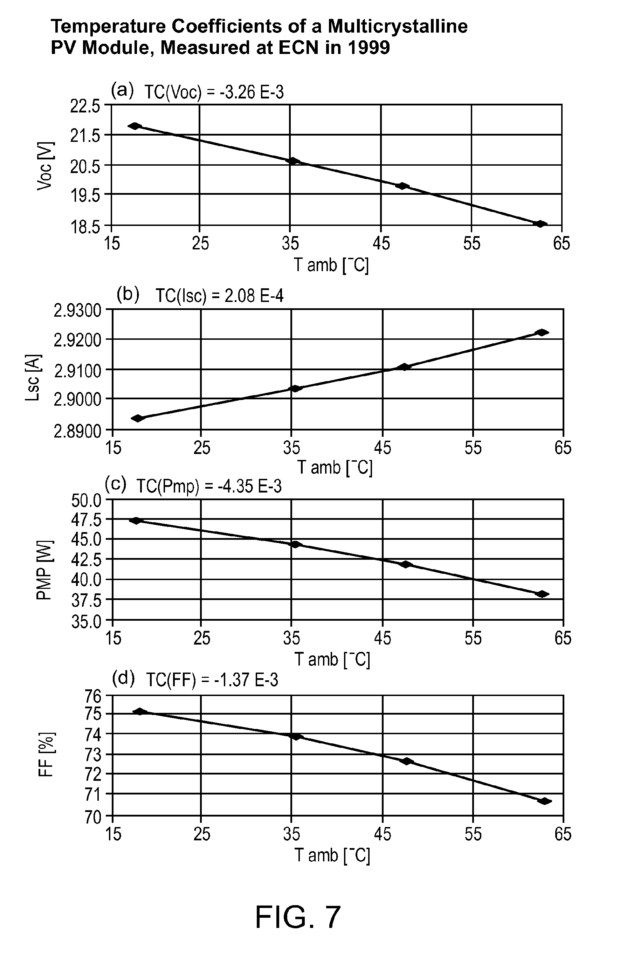

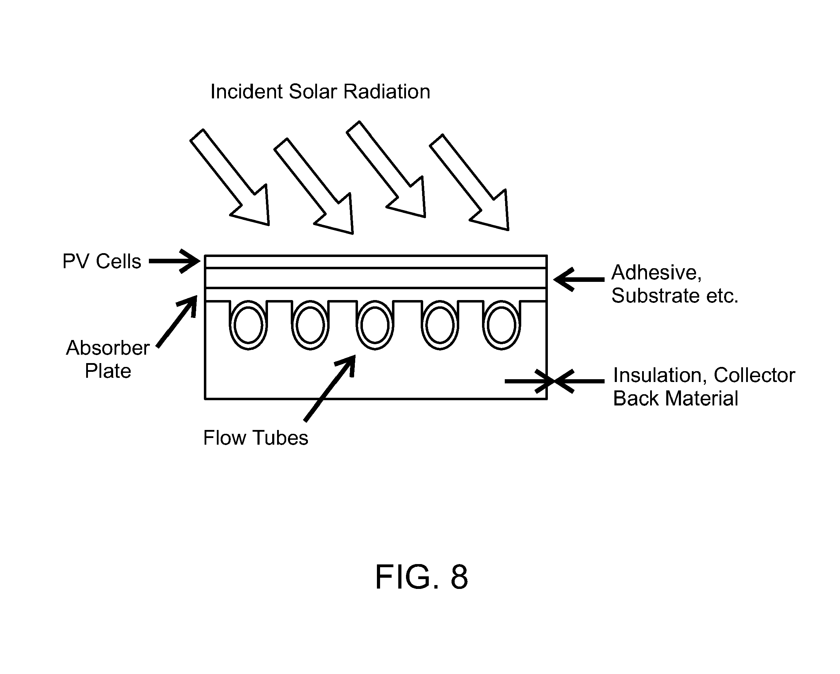

In Fig. 7, the temperature coefficient of the open circuit is 3.26 percent for every 10˚C. Fig.8 shows, the voltage reduces with temperature increase, while the current increases slightly. When the product of voltage and current is examined, the voltage coefficient wins. Hence, the module power in the maximum power point decreases by 4.35 percent/ 10˚C.

In the following, we model an un-glazed solar PVT (PV THERMAL) collector which has the dual purpose of creating power from embedded photovoltaic (PV) cells and providing heat to a fluid stream passing through tubes bonded to an absorber plate located beneath the PV cells. The model is illustrated in Fig. 8. The waste heat rejected to the fluid stream is useful for two reasons; 1) it cools the PV cells allowing higher power conversion efficiencies and 2) it provides a source of heat for many possible low-grade temperature applications, for example hot water for washing and showers, space heating, air conditioning, water desalination, and even to produce electricity by mean of co-generation.

The model of Fig. 8 relies on linear factors relating the efficiency of the PV cells to the cell temperature and also the incident solar radiation. The cells are assumed to be operating at their maximum power point condition.

The thermal model of this collector relies on algorithms presented in Chapter 6 of the classic "Solar Engineering of thermal Processes" textbook by Duffie and Beckman.

### Nomenclature

$\beta$ - slope of the collector surface $\dot{\eta}$ - efficiency $\theta$ - angle of incidence **$p$** - ground reflectance

$\tau\alpha$- transmittance-absorptance product for the solar collector $\varepsilon$ - emissivity of the top surface of the collector (PV surface) $\sigma$ -Stefan-Boltzmann constant $\lambda$ - thickness of the absorber plate

*Area* - area (top) of the solar collector; this can be either gross area or net area but should be consistent with the provided loss coefficients and PV power conversion coefficients. *b0* - incidence angle modifier multiplier *Cp* - specific heat of the fluid flowing through the PV/T collector CB - the conductance between the absorber plate and the bonded tube *D tube* - the diameter of the tubes FR - collector heat removal factor *Gt* - total solar radiation (beam + diffuse) incident upon the collector surface *hfluid* - internal fluid heat transfer coefficient *hinner* - heat transfer coefficient from the back of the collector to the air *houter* - heat transfer coefficient from the top of the collector (PV surface) to the ambient air *hrad* - radiative heat transfer coefficient from the top of the collector (PV surface) to the sky *IAM* - incidence angle modifier k - thermal conductivity of the plate material L - the length of the collector along the flow direction *m&* - flow rate of fluid through the solar collector *Ntubes* - number of identical tubes carrying fluid through the collector *Power* - rate at which electrical energy is produced by the PV cells *Qloss,top,conv* - rate at which energy is lost to the ambient through convection off the top of the collector

*Qloss,top,rad* - rate at which energy is lost to the sky through radiation off the top of the collector *Qloss,back* - rate at which energy is lost to the ambient through the back of the collector Qfluid - rate at which energy is added to the flow stream by the collector, this term includes

the energy that is also lost from the fluid stream through the back of the collector *Qabsorbed* - net rate at which energy is absorbed by the collector plate (does not include PV powerproduction) *Qu* - rate at which energy is added to the flow stream by the collector *q'fin* - heat transfer to the fin base per unit length of collector *q'fluid* - heat transfer to the fluid stream per unit length of collector *q'u* - heat transfer to the fluid stream per unit length of collector *Rt* - resistance to heat transfer from the PV cells to the absorber plate *Rb* - resistance to heat transfer from the absorber through the back of the collector *R1* - resistance to heat transfer provided by the material between the PV cells and the absorber

*R2* - resistance to heat transfer provided by the material between the absorber plate and the back surface of the collector S - net absorbed solar radiation (total absorbed ⎯ PV power production) *Tabs* - absorber plate temperature Tamb - ambient temperature for convective losses from the top surface *Tback* - environment temperature for convective losses from the bottom surface *Tfluid* - bulk temperature of the fluid flowing through the solar collector *Tfluid,in* - temperature of the fluid flowing into the solar collector *Tfluid,out* - temperature of the fluid flowing out of the solar collector *Tfluid* - local fluid temperature *TPV* - PV cell temperature *Tsky* - sky temperature for long-wave radiation calculations *T* - mean temperature *W* - the width (x-direction) between adjacent fluid tubes in the collector *Width* - the width of the collector *XCell Temp* - multiplier for the PV cell efficiency as a function of the cell temperature XNS - multiplier to account for collectors connected in series (thermally) XRadiation - multiplier for the PV cell efficiency as a function of the incident radiation *y* - a variable indicating the direction of flow through the collector

*b* - beam radiation d - diffuse radiation g - ground G - radiation h - total horizontal *n* - normal incidence *nominal* - refers to the reference conditions *PV* - photovoltaic s - sky diffuse t - total (beam + diffuse)

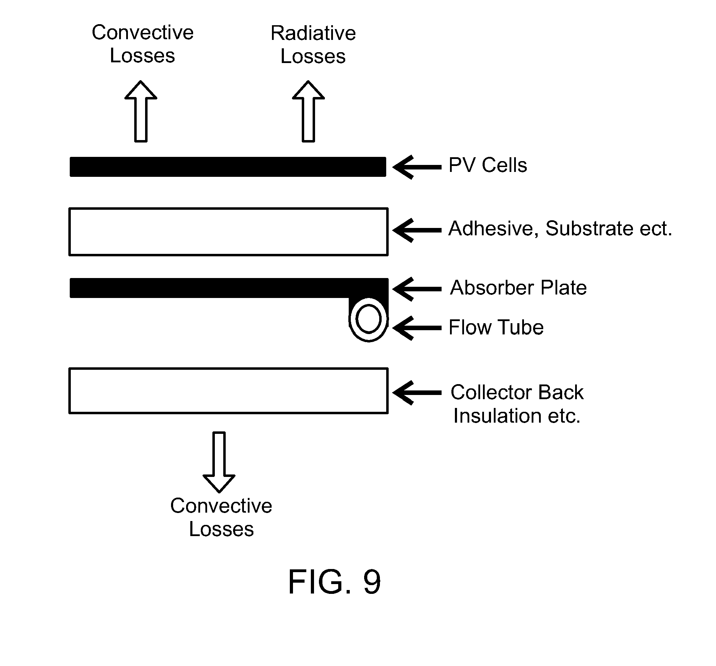

With reference to Fig. 9, an energy balance on the collector surface (PV cells) at any point along the surface, (neglecting conduction along the surface) shows the following relationship:

equation 2:

$$0 = S - h_{conv}(T_{PV} - T_{amb}) - h_{rad}(T_{PV} - T_{sky}) - \frac{(T_{PV} - T_{abs})}{R_T}$$

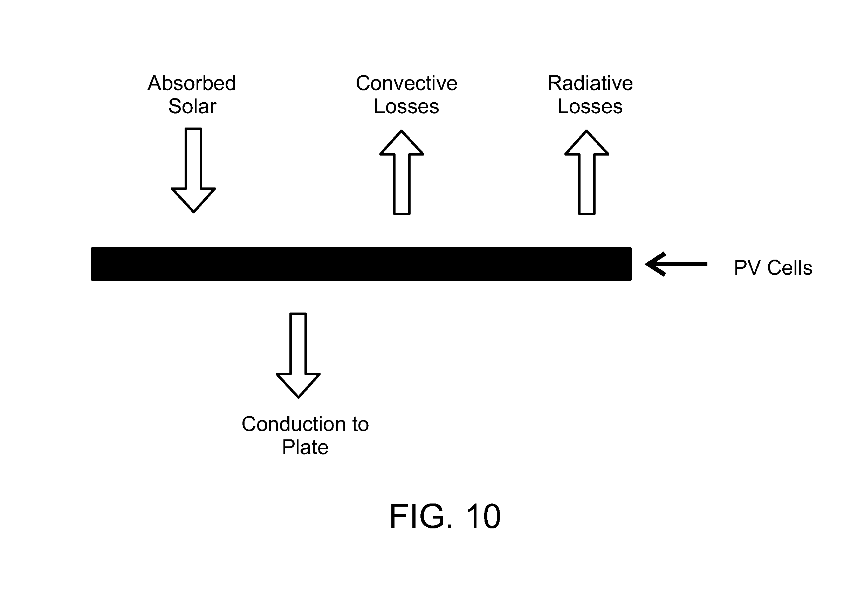

The relationship is shown schematically in Fig. 10.

Equation 3:

$$R_T = R_1$$

$$h_{rad} = \varepsilon\sigma\left(T_{PV} + T_{sky}\right)\left(T_{PV}{}^2 + T_{sky}{}^2\right)$$

S is the net absorbed solar radiation and accounts for the absorbed solar radiation minus the PV power production. To account for off-normal solar radiation effects, the transmittance-absorptance product at normal incidence is multiplied by the following term in order to get the transmittance absorptance at other incidence angles. This term is referred to as the incidence angle modifier (IAM).

Equation 4:

$$IAM = \frac{(\tau\alpha)}{(\tau\alpha)_n} = \frac{G_{bT}\frac{(\tau\alpha)_b}{(\tau\alpha)_n} + G_d\frac{(1 + \cos\beta)}{2}\frac{(\tau\alpha)_d}{(\tau\alpha)_n} + G_b\,\rho_g\frac{(1 - \cos\beta)}{2}\frac{(\tau\alpha)_g}{(\tau\alpha)_n}}{G_T}$$

Where Equation 5: $\dfrac{(\tau\alpha)_b}{(\tau\alpha)_n} = 1 - b_0\left(\dfrac{1}{\cos\theta} - 1\right)$

The incidence angle modifiers for both sky and diffuse radiation are determined by defining equivalent incidence angles for beam radiation that give the same transmittance as for diffuse radiation (Duffie and Beckman). The effective angles for sky diffuse and ground reflected radiation are:

Equation 6:

$$\theta_{sky} = 59.68 \; - \; 0.1388 \, \beta \; + \; 0.001497 \, \beta^2$$

$$\theta_{ground} = 90.0 \; - \; 0.5788 \, \beta \; + \; 0.002693 \, \beta^2$$

Equation 7:

With these definitions S, the net absorbed solar radiation, from equation 1 can be determined as:

$$S = (\tau\alpha)_n \; IAM \; G_T \; (1 - \eta_{PV})$$

The efficiency of the PV cells is a function of the cell temperature and the incident solar radiation:

Equations 9, 10 and 11 are shown below in sequence

$$\eta_{PV} = \eta_{nominal} \; X_{CellTemp} \; X_{Radiation}$$

$$X_{CellTemp} = 1 + Eff_T \left( T_{PV} - T_{ref} \right)$$

$$X_{Radiation} = 1 + Eff_G \left( G_T - G_{ref} \right)$$

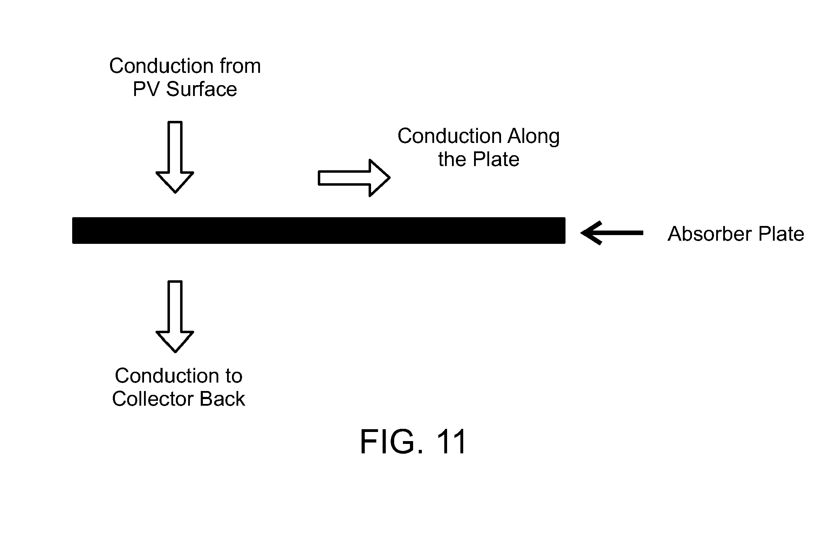

An energy balance, illustrated in Fig. 11, may be taken for a differential sized section along the absorber plate, at any point along the plate away from the tube section, and may show the following relationship (assuming the plate is thin and made from a conductive material):

Equation 12:

$$k\lambda\frac{d^2T_{abs}}{dx^2} = \frac{(T_{abs} - T_{back})}{R_8} - \frac{(T_{PV} - T_{abs})}{R_7}$$

Where equation 13: $R_8 = R_2 + \frac{1}{h_{inner}}$

This is a classical fin problem where the absorber plate section between the midpoint of two adjacent tubes and the tube acts as the fin. Solving Equation 1 for TPV and substituting into Equation 12, we derive the following differential equation for the temperature distribution (xdirection) along the absorber plate:

$$\frac{d^2T_{abs}}{dx^2} = \frac{F'}{k\lambda}\left[T_{abs}\left(\frac{1}{R_7F'} + \frac{1}{R_8F'} - \frac{1}{R_7}\right) - \left(S + h_{rad}T_{sky} + h_{outer}T_{amb} + \frac{T_{back}}{R_8F'}\right)\right]$$

Where equation 15: $F' = \dfrac{1}{h_{rad}R_7 + h_{outer}R_7 + 1}$

We can recast Equation 4 as equation 16: $\dfrac{d^2\Psi}{dx^2} - m^2\Psi = 0$

Where equation 7: $\Psi = T_{abs} - \dfrac{S + h_{rad}T_{sky} + h_{outer}T_{amb} + \dfrac{T_{back}}{R_8F'}}{\dfrac{1}{R_7F'} + \dfrac{1}{R_8F'} - \dfrac{1}{R_7}}$

Equation 18:

$$m = \sqrt{\frac{F'\left(\dfrac{1}{R_7F'} + \dfrac{1}{R_8F'} - \dfrac{1}{R_7}\right)}{k\lambda}}$$

Solving Equation 16 we find wit equation 19: $\Psi = C_1\sinh(mx) + C_2\cosh(mx)$

Equation 19 defines the temperature distribution along the plate in the x-direction, where x=0 is the midpoint between two adjacent tubes and x=(W-Dtube)/2 is the base of the fin. To find the constants C1 and C2, we need to apply our boundary conditions. For this problem we have the boundary conditions from symmetry at the midpoint between adjacent tubes (x=0) and from the known base temperature (Tb) at x=(W-Dtube)/2:

Equation 20:

$$\frac{d\Psi}{dx} = 0 \quad at \ x = 0$$

Equation 21:

$$\Psi = T_b - \frac{S + h_{rad}T_{sky} + h_{outer}T_{amb} + \frac{T_{back}}{R_B F'}}{\frac{1}{R_T F'} + \frac{1}{R_B F'} - \frac{1}{R_T}} \quad at \ x = (W - D_{tube})/2$$

Applying our boundary conditions and solving for C1 and C2 we find: Equation 22:
$C_1 = 0$

Equation 23:

$$C_2 = \frac{T_b - \left( \frac{S + h_{rad}T_{sky} + h_{outer}T_{amb} + \frac{T_{back}}{R_B F'}}{\frac{1}{R_T F'} + \frac{1}{R_B F'} - \frac{1}{R_T}} \right)}{\cosh\left( m \frac{(W - D_{tube})}{2} \right)}$$

Substituting C1 and C2 into Equation 19, and then applying Equation 17, we derive the expression for the temperature distribution along the plate as a function of the base temperature:

Equation 24:

$$T_{abs}(x) = \frac{b}{j} + \left( T_b - \frac{b}{j} \right) \frac{\cosh(m\,x)}{\cosh\left( m \frac{(W - D_{tube})}{2} \right)}$$

Where equation

$$\frac{b}{j} = \left( \frac{S + h_{rad}T_{sky} + h_{water}T_{amb} + \frac{T_{back}}{R_B F'}}{\frac{1}{R_T F'} + \frac{1}{R_B F'} - \frac{1}{R_T}} \right)$$ 25:

With the temperature distribution known along the fin (equation 24), we can calculate the energy conducted to the base from the fin:

Equation 26:

$$q'_{fin} = -k\,\lambda\frac{dT_{abs}(x)}{dx} = k\,\lambda\,m\,(\frac{b}{j} - T_b)\tanh\left( m\left( \frac{W - D_{tube}}{2} \right) \right)$$

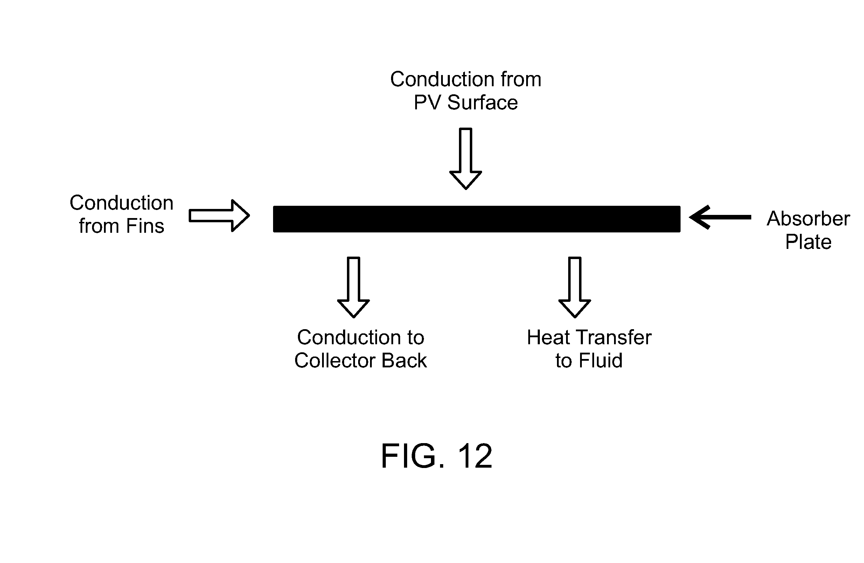

An energy balance on the base (non- fin) area of the absorber, is illustrated in Fig. 12 and shows:

$$q'_{fluid} = D_{tube}\left( \frac{T_{PV} - T_B}{R_T} \right) - D_{tube}\left( \frac{T_B - T_{Back}}{R_B} \right) + 2q'_{fin}$$

The useful energy gain to the fluid may also be expressed as a function of the base temperature:

Equation 28:

$$q'_{fluid} = \left( \frac{T_B - T_{fluid}}{\frac{1}{h_{fluid}\,\pi\,D_{tube}} + \frac{1}{C_B}} \right)$$

An expression for the collector useful energy gain as a function of the fluid temperature may be derived by substituting terms from equations 1, 26 and 28 into Equation 27 and rearranging:

Equation 29:

$$q'_{fluid} = \frac{\kappa}{\theta}T_{fluid} + \frac{\varepsilon}{\theta}$$

Where equation 30:

$$\kappa = -D_{tube}F'\left(h_{rad} + h_{outer} + \frac{1}{R_B F'}\right) - 2k\lambda m \tanh\left(m\left(\frac{W - D_{tube}}{2}\right)\right)$$

Equation 31:

$$\theta = 1 + D_{tube}F'\left(\frac{1}{h_{fluid}\pi D_{tube}} + \frac{1}{C_B}\right)\left(h_{rad} + h_{outer} + \frac{1}{R_B F'}\right)$$

$$+ 2k\lambda m \tanh\left(m\left(\frac{W - D_{tube}}{2}\right)\right)\left(\frac{1}{h_{fluid}\pi D_{tube}} + \frac{1}{C_B}\right)$$

Equation 32:

$$\varepsilon = D_{tube}F'\left(S + h_{rad}T_{sky} + h_{outer}T_{amb} + \frac{T_{back}}{R_B F'}\right)$$

$$+ 2k\lambda m \tanh\left(m\left(\frac{W - D_{tube}}{2}\right)\right)\left(\frac{S + h_{rad}T_{sky} + h_{outer}T_{amb} + \dfrac{T_{back}}{R_B F'}}{\dfrac{1}{R_T F'} + \dfrac{1}{R_B F'} - \dfrac{1}{R_T}}\right)$$

An energy balance taken around a differential section of fluid moving through the collector (in the y direction) can be written as:

$$\dot{m}C_p \frac{dT'_{fluid}}{dy} - N_{tubes}\, q'_{fluid} = 0$$

Subbing Equation 29 into Equation 33 we find:

$$\frac{dT_{fluid}}{dy} = \frac{N_{tubes}}{\dot{m}C_p}\frac{\kappa}{\theta}T_{fluid} + \frac{N_{tubes}}{\dot{m}C_p}\frac{\varepsilon}{\theta}$$

Integrating this equation from zero to y we find:

$$T_{fluid}(y) = \left( T_{fluid,in} + \frac{\varepsilon}{\kappa} \right) \exp\left( \frac{N_{tubes}}{\dot{m} C_p} \frac{\kappa}{\theta} y \right) - \frac{\varepsilon}{\kappa}$$

If we let y=L, we can solve for the fluid outlet temperature:

$$T_{fluid,out} = \left( T_{fluid,in} + \frac{\varepsilon}{\kappa} \right) \exp\left( \frac{N_{tubes}}{\dot{m} C_p} \frac{\kappa}{\theta} L \right) - \frac{\varepsilon}{\kappa}$$

The collector useful energy gain can now be calculated: Equation 37: And the collector useful energy gain per unit length can be calculated as:

$$Q_u = \dot{m} C_p \left( T_{fluid,out} - T_{fluid,in} \right)$$

$$q'_u = q'_{fluid} = \frac{\dot{m} C_p \left( T_{fluid,out} - T_{fluid,in} \right)}{L\, N_{tubes}}$$

The mean fluid temperature can be found by integrating the fluid temperature with respect to y and dividing by the flow length:

Equation 39:

$$\overline{T}_{fluid} = \frac{1}{L} \int_0^L T_{fluid}(y)\, dy$$

Using Equation 35 and 39 and solving the differential equation we find: With mean fluid temperature found from Equation 40, and the collector useful energy gain per unit length found from Equation 38, the mean base temperature can be solved from Equation

$$\overline{T}_{fluid} = \left( \frac{T_{fluid,in} + \dfrac{\varepsilon}{\kappa}}{\dfrac{N_{tubes}}{\dot{m} C_p} \dfrac{\kappa}{\theta} L} \right) \exp\left( \frac{N_{tubes}}{\dot{m} C_p} \frac{\kappa}{\theta} L \right) - \left( \frac{T_{fluid,in} + \dfrac{\varepsilon}{\kappa}}{\dfrac{N_{tubes}}{\dot{m} C_p} \dfrac{\kappa}{\theta} L} \right) - \frac{\varepsilon}{\kappa}$$

28. With the mean base temperature solved, the temperature distribution across the absorber (fin section) can be found from applying Equation 24.

The mean fin temperature can then be found by integrating the fin temperature function over the width of the fin, and dividing by the fin width:

Equation 41:

$$\overline{T}_{fin} = \int_0^{\left(\frac{W-D_{tube}}{2}\right)} T(x)dx \qquad \overline{T}_{fin} = \frac{S + h_{rad}T_{sky} + h_{conv}T_{amb} + \frac{T_{back}}{R_B F'}}{\frac{1}{R_T F'} + \frac{1}{R_B F'} - \frac{1}{R_T}} +$$

Equation 42:

$$\frac{\left( \overline{T}_B - \frac{S + h_{rad}T_{sky} + h_{conv}T_{amb} + \frac{T_{back}}{R_B F'}}{\frac{1}{R_T F'} + \frac{1}{R_B F'} - \frac{1}{R_T}} \right) \tanh\left( m\left( \frac{W - D_{tube}}{2} \right) \right)}{m\left( \frac{W - D_{tube}}{2} \right)}$$

The mean absorber temperature can then be found by area weighting the mean base temperature and the mean fin temperature:

$$\overline{T}_{abs} = \frac{\left( D_{tube}\overline{T}_B + (W - D_{tube})\overline{T}_{fin} \right)}{W}$$

The mean PV surface temperature ( $PV\,T$ ) can then be found from Equation 1. The solution of this set of equations requires an iterative approach as S is a function of the mean PV surface temperature:

1. 1. Guess a value for the PV surface temperature.
2. 2. Calculate the radiation heat transfer coefficient using equation 3.
3. 3. Calculate the PV efficiency using equations 9 and 10.
4. 4. Calculate the net absorbed solar radiation using equation 8.
5. 5. Calculate the fluid outlet temperature using equation 36 and the mean fluid temperature using equation 40.
6. 6. Calculate the collector useful energy gain per unit length using equation 38.
7. 7. Calculate the mean base temperature from Equation 28.
8. 8. Calculate the mean fin temperature from Equation 42.
9. 9. Calculate the mean absorber temperature from Equation 43.
10. 10. Calculate the mean PV surface temperature using Equation 1 and repeat steps 2 to 9 until convergence is reached.

With convergence attained, equation 6.9.3 from Duffie and Beckman can be used to find the overall loss coefficient from the collector (UL):

$$Q_u = Area\left[ S - U_L \left( \overline{T}_{abs} - T_{amb} \right) \right]$$

Finally, with the collector overall loss coefficient calculated, the collector heat removal factor can be calculated from equation 6.7.6 of Duffie and Backman:

$$Q_u = Area\ F_R \left[ S - U_L \left( T_{fluid,in} - T_{amb} \right) \right]$$

With the PV cell temperature converged the PV power can be calculated: Equation 46:

$$Power = G_T\ Area\ \eta_{PV}$$

The remaining relevant heat transfers for the collector are then calculated as:

Equation 47:

Equation 48:

$$Q_{loss,top,conv} = h_{outer}\ Area \left( \overline{T}_{PV} - T_{amb} \right)$$

$$Q_{loss,top,rad} = h_{rad}\ Area \left( \overline{T}_{PV} - T_{sky} \right)$$

$$Q_{loss,back} = Area\ \frac{\left( \overline{T}_{abs} - T_{back} \right)}{R_B}$$

$$Q_{PV \rightarrow Plate} = Area \left( \frac{\overline{T}_{PV} - \overline{T}_{ABS}}{R_I} \right)$$

$$Q_{absorbed} = A\ (\tau\alpha)_n\ IAM\ G_T\ (1 - \eta_{PV})$$

An energy balance on the collector surface is then:

$$Q_{absorbed} = Q_{loss,top,conv} + Q_{loss,top,rad} + Q_{PV \rightarrow plate}$$

An energy balance on the entire collector can also be written:

$$Q_{absorbed} = Q_{loss,top,conv} + Q_{loss,top,rad} + Q_u + Q_{loss,back}$$

TRNSYS Component Configuration

| PARAMETERS | | | | |
|---|---|---|---|---|
| Parameter Number | Name | Unit | Typical Value | Comment |
| 1 | Length | m | 1.0 | The length of the collector direction along the tubes). |
| 2 | Width | m | 1.0 | The width of the collector (direction across the tubes). |
| 3 | Absorber thickness | m | 0.0005 | The thickness of the absorber plate (the plate bonded to the tubes). |
| 4 | Thermal conductivity of the absorber | kJ/h.mK | 1386. | The thermal conductivity of the absorber plate (the plate bonded to the tubes). |
| 5 | Number of tubes | - | 10 | The number of identical fluid tubes bonded to the absorbed plate. |
| 6 | Tube diameter | m | 0.01 | The diameter of the fluid tubes bonded to the absorber plate. |
| 7 | Bond width | m | 0.01 | The average Width of the bond between the tube and the absorber plate. |
| 8 | Bond thickness | m | 0.001 | The average thickness of the bond between the tube and the absorber plate. |
| 9 | Bond thermal conductivity | kJ/h.mK | 1386. | The thermal conductivity of the bond between the absorber plate and the tubes. |
| 10 | Resistance of substrate maternal | h.m$^2$ K.kJ | 0.01 | The resistance to heat transfer of the maternal located between the PV cells and the absorber plate (adhesive substrate etc.). |
| 11 | Resistance of back material | h.m$^2$ K.kJ | 3.0 | The resistance to heat transfer for the back of the collectors (material(s) located between the absorber plate and the back-side air) |
| 12 | Fluid specific heat | kJ/kg.K | 4.190 | The specific heat of the fluid flowing through the solar collector. |

(continued)

| PARAMETERS | | | | |
|---|---|---|---|---|
| Parameter Number | Name | Unit | Typical Value | Comment |
| 13 | Reflectance | - | 0.15 | The overall reflectance of the collector surface at normal incidence. The transmittance-absorptance product at normal incidence is found by subtracting this value from 1. |
| 14 | Emissivity | - | 0.9 | The emissivity of the collector surface for long-wave radiation exchange with the sky. |
| 15 | 1st order IAM | - | 0.1 | 1st order coefficient in the IAM function ($b_0$). |
| 16 | PV cell reference temperature | C | 20.0 | The reference temperature at which the efficiency of the PV cell is provided. |
| 17 | PV cell reference radiation | kJ/h.m2 | 3600.0 | The reference total incident solar radiation at which the efficiency of the PV cell is provided |
| 18 | PV efficiency at reference condition | - | 0.12 | The efficiency of the PV cells in converting incident radiation to electricity at the provided reference conditions. |
| 19 | Efficiency modifier-temperature | 1/C | -0.005 | The multiplier to correct the rated PV cell efficiency as a function of cell temperature |
| 20 | Efficiency modifier - radiation | h.m2/kJ | 0.000025 | The multiplier to correct the rated PV cell efficiency as a function of incident solar radiation |

| INPUTS | | | | |
|---|---|---|---|---|
| Input Number | Name | Unit | Typical Value | Comment |
| 1 | Inlet temperature | C | 20.0 | The temperature of the fluid entering the collector at the flow inlet. |
| 2 | Inlet flow rate | kg/hr | 200.0 | The flow rate of fluid entering the collector at the fluid inlet. |
| 3 | Ambient temperature | C | 20.0 | The temperature of the environment for calculating losses from the collector surfaces (top and back). |
| 4 | Sky temperature | C | 20.0 | The temperatures of the sky for calculating long-ware radiation losses from the collector surface. |

(continued)

| INPUTS | | | | |
|---|---|---|---|---|
| Input Number | Name | Unit | Typical Value | Comment |
| 5 | Back-surface environment temperature | C | 20.0 | The temperature of the air located behind the back surface of the collector. |
| 6 | Incident solar radiation | kJ/hr- m$^2$ | 0.0 | The rate at which incident solar radiation (beam -diffuse) strikes the sloped collector surface, |
| 7 | Total horizontal radiation | kJ/hr- | 0.0 | The rate at which total solar radiation (beam + diffuse) strikes a horizontal surface.total solar (beam |
| 8 | Horizontal diffuse radiation | MJ/hr- m$^2$ | 0.0 | The rate at which diffuse radiation strikes a horizontal surface. |
| 9 | Ground reflectance | - | 0.2 | The reflectance to solar radiation of the surface upon which the collector is located. |
| 10 | Incidence angle | degrees | 0.0 | The angle of incidence between beam solar radiation and the sloped collector surface. |
| 11 | Collector slope | degrees | 45.0 | The slope of the collector surface of the ICS enclosure (0=horizontal, 90=vertical facing the azimuth). |
| 12 | Top loss convection coefficient | kJ/hr- nr-K | 20.0 | The convective heat loss coefficient from the top of the collection to the ambient (does not include radiative losses). |
| 13 | Back loss coefficient | kJ/hr- m$^2$-K | 20.0 | The loss coefficient from the back of the collector to the ambient (includes radiative losses). |
| 14 | Fluid heat transfer coefficient | kJ/hr- m$^2$-K | 200.0 | The heat transfer coefficient from the fluid in the flow channels to the walls of the fluid channel enclosure. |

| OUTPUTS | | | |
|---|---|---|---|
| Output Number | Name | Unit | Comment |
| 1 | Temperature at outlet | C | The temperature of the fluid exiting the collector |
| 2 | Flow rare at outlet | kg/hr | The flow rate of fluid exiting the collector. |
| 3 | Useful energy gain | kJ/hr | The net rate at which energy is transferred to the fluid flowing through the solar collector. |
| 4 | PV power | kJ/hr | The rate at which the photovoltaic cells are producing eletrical power. |

(continued)

| | OUTPUTS | | |
|---|---|---|---|
| Output Number | Name | Unit | Comment |
| 5 | PV efficiency | - | The efficiency of the PV cells in converting incident solarradiation to electrical energy: expressed as a fraction. |
| 6 | Thermal efficiency | - | The efficiency of the solar collector in converting incident solar radiation to delivered fluid energy. |
| 7 | Collector $F_R$ | - | The calculated collector heat removal factor |
| 8 | Mean PV temperature | C | The temperature of the PV cells. |
| 9 | Mem fluid temperature | C | The mean temperature of the fluid in the solar collector. |
| 10 | Overall IAM | - | The overall (beam plus diffuse) incidence angle modifier for the collector. |
| 11 | Collector top losses - convective | kJ/hr | The rate at which energy is lost to the environment through convection from the top surface of the collector. |
| 12 | Collector top losses - radiative | kJ/hr | The rate at which energy is lost to the environment through radiation losses from the top surface of the collector. |
| 13 | Back losses | kJ/hr | The rate at which energy is lost to the environment through the back surface of the collector. |
| 14 | Absorbed solar radiation | kJ/hr | The net rate at which solar radiation is absorbed by the collector. This value does not include the radiation that was absorbed by the PV cells and converted to electrical energy |
| 15 | Collector $U_L$ | kJ/hr- $m^2$-K | The calculated overall loss coefficient for this collector. |
| 16 | $F_R I\alpha_N$ | - | The intercept term for the collector efficiency equation. |
| 17 | $F_R U_L$ | kJ/hr- $m^2$-K | The linear term for the collector efficiency equation. |

The following models an unglazed solar collector which has the dual purpose of creating power from embedded photovoltaic (PV) cells and providing heat to an air and water stream passing beneath the absorbing PV surface. The waste heat rejected to the air stream is useful for two reasons; 1) it cools the PV cells allowing higher power conversion efficiencies and 2) it provides a source of heat for many possible low- grade temperature applications including heating of room air. This model is intended to operate with simple building models that can provide the temperature of the zone air on the back-side of the collector and possibly provide an estimate of the radiant temperature for back-side radiation calculations (the room air temperature may be used as a suitable estimate of the radiant temperature if surface temperatures are not available).

The model allows for the user to choose between two methods of handling the off-normal solar radiation effects. The model allows the user three options on specifying how the cell temperature, and the incident solar radiation affect the PV efficiency. The cells are assumed to be operating at their maximum power point condition; implying that the voltage and current are not calculated by the model.

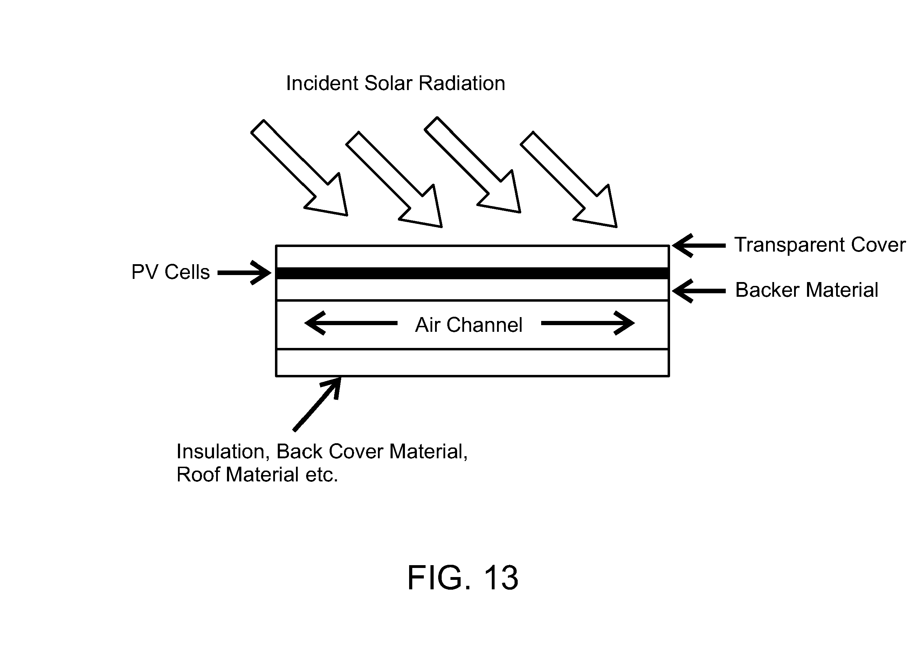

The thermal model of this collector relies on algorithms supplied by the classic "Solar Engineering of Thermal Processes" textbook by Duffie and Beckman. The model is illustrated in Fig. 13.

*Nomenclature*

$M_\beta$ - slope of the collector surface fluid- the viscosity of the fluid flowing through the channel ἠ - efficiency θ - angle of incidence of solar radiation pg -ground reflectance ρ*fluid* -the density of the fluid in the flow channel τα — transmittance-absorptance product for the solar collector ε back - emissivity of the back surface of the collector (towards zone) ε cover - emissivity of the cover surface of the collector (towards sky) ε1 - emissivity of the bottom side of the upper surface of the air channel ε2 - emissivity of the top side of the lower surface of the air channel σ - Stefan-Boltzmann constant **v***fluid* -the viscosity of the fluid in the flow channel $\Delta T$ *plates* - the temperature difference between the plates defining the flow channel **Area** - area (top) of the solar collector; this can be either gross area or net area but should be consistent with the provided loss coefficients and PV power conversion coefficients.

*b0* - incidence angle modifier multiplier

*Cp fluid* - the specific heat of the fluid in the flow channel *Dh* - the hydraulic diameter of the flow channel *EffG* - modifier for PV efficiency as a function of incident solar radiation *EffT* - modifier for PV efficiency as a function of cell temperature g - the acceleration due to gravity *GbT* - incident beam radiation on the tilted cover surface *Gd* - incident sky diffuse radiation on the tilted cover surface *Gh* - horizontal diffuse radiation *Gref* - reference solar radiation at which the standard PV efficiency is given *GT* - total incident solar radiation on the collector surface *hconv,back* - convective heat transfer coefficient from the back of the collector to the zone air *hconv,top* - convective heat transfer coefficient from the top of the cover surface to the ambient air

*hfluid* - heat transfer coefficient from the fluid in the flow channels to the walls of the flow channel (evaluated at the mean fluid temperature) *hrad, 1-2* - the linearized radiation heat transfer coefficient from the top surface of the air channel to the bottom surface of the air channel

*hrad,back* - radiative heat transfer coefficient from the back of the collector to the zone radiant temperature *hrad,top* - radiative heat transfer coefficient from the top of the cover surface to the sky *IAM* - incidence angle modifier *kcover* - thermal conductivity of the cover material

*kfluid* - thermal conductivity of the fluid in the flow channel L - the length of the collector along the flow direction m - the flow rate of fluid through the channel *Nu* - the Nusselt number for the fluid in the flow channel *Pr* - the Prandtl number for the fluid in the flow channel *qu"* - net rate at which energy is added to the flow stream by the collector per unit area *Qabsorbed* - rate at which energy is absorbed by the collector Qloss,top,conv - rate at which energy is lost to the ambient through convection off the cover +*Qloss,top,rad* - rate at which energy is lost to the sky through radiation off the cover *Qloss,back,conv* - rate at which energy is lost to the zone through convection

*Qloss,back,rad* - rate at which energy is lost to the zone through radiation off the back of the collector Qu - net rate at which energy is added to the flow stream by the collector *Ra* - the Rayleigh number of the fluid in the channel *Re* - the Reynolds number of the fluid flowing through the channel *R1* - resistance to heat transfer from the top of the cover surface to the PV cells (typically the resistance of the cover material)

*R2* - resistance to heat transfer from the surface of the PV cells to the upper surface of the

flow channel *R3* - resistance to heat transfer from the lower surface of the flow channel to the back-side of the collector

S - the absorbed solar radiation minus any PV power production *Slope* - the slope of the flow channel off of horizontal (vertical =90) *Spacing* - the spacing between the plates defining the flow channel *T1* - temperature of the upper air-channel surface *T2* - temperature of the lower air-channel surface *T3* - temperature of the back surface of the collector (zone air / collector interface) *Tamb* - ambient temperature for convective losses from the cover surface *Tback* - temperature of the air behind the collector (zone air) *Tback,rad* - temperature of the surroundings behind the collector for back-side radiation heat

transfer *TCover* - temperature of the outer surface of the transparent cover material *Tfluid* - local temperature of the fluid flowing through the solar collector *Tfluid, in* - temperature of the fluid flowing into the solar collector *Tfluid, out* - temperature of the fluid flowing out of the solar collector *TPV* - temperature of the absorbing surface of

the PV cells *Tref* - reference temperature at which the standard PV efficiency is given *Tsky* - sky temperature for radiative losses from the cover surface *THcover* - thickness of the cover material *Tplates* - the average temperature of the plates defining the flow channel T fluid - mean fluid temperature W - the width of the collector *XCell Temp* - multiplier for the PV cell efficiency as a function of the cell temperature *XRadiation* - multiplier for the PV cell efficiency as a function of the incident radiation *y* - a variable indicating the direction of flow through the collector

(y=L is the collector outlet)

## Subscripts

*b* - beam radiation d - diffuse radiation g - ground G - radiation h - total horizontal *n* - normal incidence *nominal* - refers to the reference conditions *PV* - photovoltaic s - sky diffuse t - total (beam + diffuse)

**Mathematical description:**

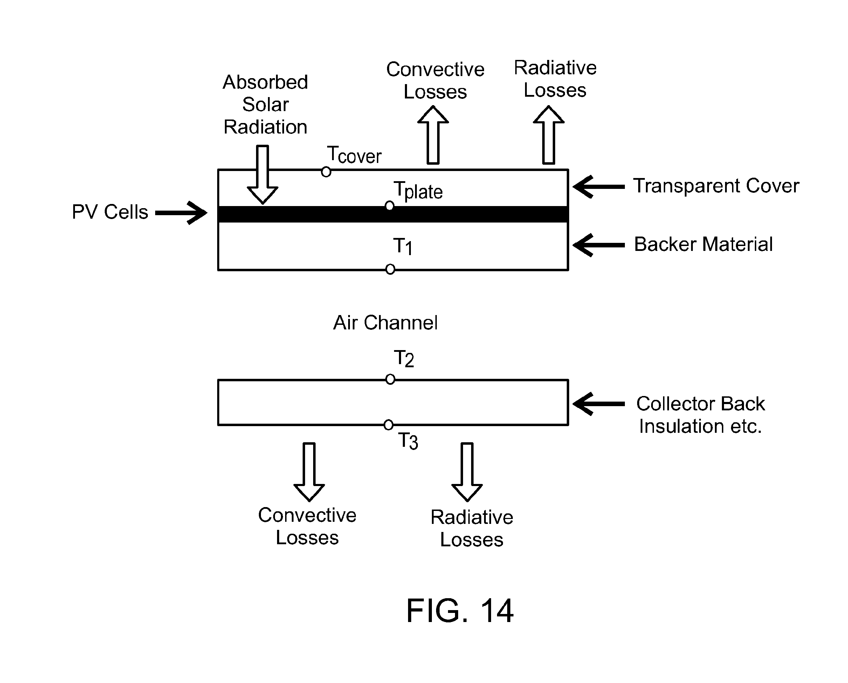

An energy balance on the cover surface at any point along the surface is illustrated in Fig. 14 and shows the following relationship:

$$\text{Equation 1:} \quad \frac{(T_{PV} - T_{Cover})}{R_1} = h_{conv,top}(T_{Cover} - T_{amb}) - h_{rad,top}(T_{Cover} - T_{sky})$$

Where equation 2: $h_{rad,top} = \varepsilon_{Cover} \sigma (T_{Cover} + T_{sky})(T_{Cover}^2 + T_{sky}^2)$

$$\text{Equation 3:} \quad R_1 = \frac{TH_{Cover}}{k_{Cover}}$$

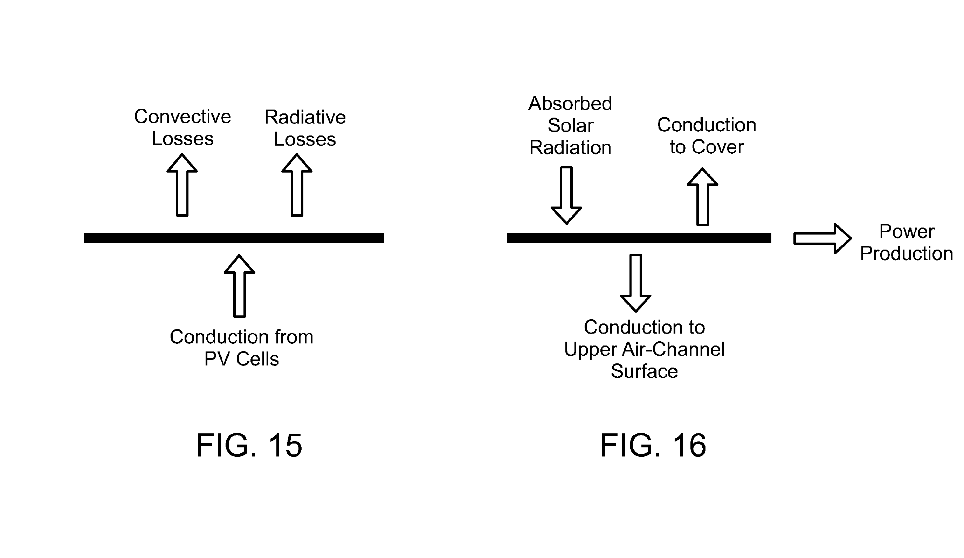

An energy balance on the PV surface (absorbing surface) at any point along the surface is illustrated in Fig 15 and in more detail in Fig. 16 and shows the following relationship:

Equation 4:

$$S = \frac{(T_{PV} - T_{Cover})}{R_1} + \frac{(T_{PV} - T_1)}{R_2}$$

S is the absorbed solar radiation minus any PV power production. To account for off-normal solar radiation effects, the transmittance-absorptance product at normal incidence is multiplied by the following term in order to get the transmittance-absorptance at other incidence angles. This term is referred to as the incidence angle modifier (IAM).

Equation 5:

$$IAM = \frac{(\tau\alpha)}{(\tau\alpha)_n} = \frac{G_{bT} \dfrac{(\tau\alpha)_b}{(\tau\alpha)_n} + G_d \dfrac{(1+\cos\beta)}{2} \dfrac{(\tau\alpha)_d}{(\tau\alpha)_n} + G_h \rho_g \dfrac{(1-\cos\beta)}{2} \dfrac{(\tau\alpha)_g}{(\tau\alpha)_n}}{G_T}$$

This model allows the user to choose two different modes for calculating the incidence angle modifiers. In mode 1, the user provides a linear incidence angle modifier constant (b0) used to calculate the IAM as well at the transmittance absorptance product at normal incidence

Equation 6:

$$\frac{(\tau\alpha)}{(\tau\alpha)_n} = 1 - b_0 \left( \frac{1}{\cos\theta} - 1 \right)$$

In mode 2, the user enters parameters about the cover material, as well as the absorptance of the PV surface, and the model uses the TALF subroutine (refer to section 3.4.3 of the TRNSYS manual) to calculate the transmittance-absorptance product at normal incidence.

The incidence angle modifiers for both sky and diffuse radiation are determined by defining equivalent incidence angles for beam radiation that give the same transmittance as for diffuse radiation (Duffie and Beckman). The effective angles for sky diffuse and ground reflected radiation are:

$$\theta_{sky} = 59.68 \ - \ 0.1388\,\beta \ + \ 0.001497\,\beta^2$$

$$\theta_{ground} = 90.0 \ - \ 0.5788\,\beta \ + \ 0.002693\,\beta^2$$

The efficiency of the PV cells is typically a function of the cell temperature and the incident

solar radiation. This model allows the user to choose from one of three PV efficiency modes. In the first mode, the user enters the PV efficiency at reference conditions, provides the reference conditions and also provides linear modifying factors for the efficiency. The efficiency is then calculated as:

Equation 9: Where: Equation 10: Equation 11:

$$\eta_{PV} = \eta_{nominal}\, X_{CellTemp}\, X_{Radiation}$$

$$X_{CellTemp} = 1 + Eff_T \left( T_{PV} - T_{ref} \right)$$

$$X_{Radiation} = 1 + Eff_G \left( G_T - G_{ref} \right)$$

In the second mode, the user must provide a data file containing the efficiency of the PV cells as a function of the cell temperature and the incident solar radiation.

$$\eta_{PV} = f\left( Cell\ Temperaure\ \&\ Incident\ Radiation \right)$$

In the third mode, the user provides the efficiency as an INPUT to the model (provides great flexibility to calculate the efficiency as a function of any subset of variables):

Equation 13:

With these definitions S, the net absorbed solar radiation from equation 4, can be determined

$$\eta_{PV} = An\ Input\ to\ the\ Model$$

as:

Equation 14:

An energy balance on the upper air channel surface at any point along the surface shows the

$$S = (\tau\alpha)_a\ IAM\ G_T\ (1-\eta_{PV})$$

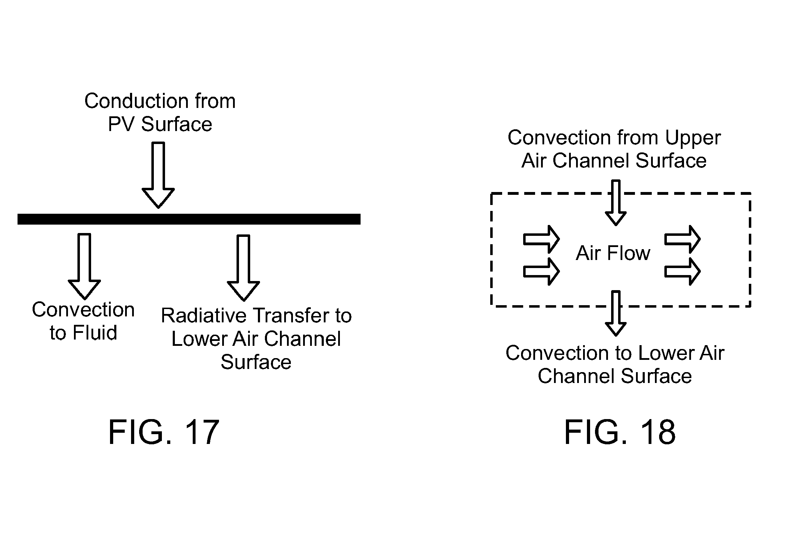

following relationship, as per Fig. 17:

$$\frac{(T_{PV} - T_1)}{R_2} = h_{fluid}(T_1 - T_{fluid}) - h_{rad,1\rightarrow2}(T_1 - T_2)$$

An energy balance on the air flowing through the collector at any point shows the following relationship, as shown in Fig. 18:

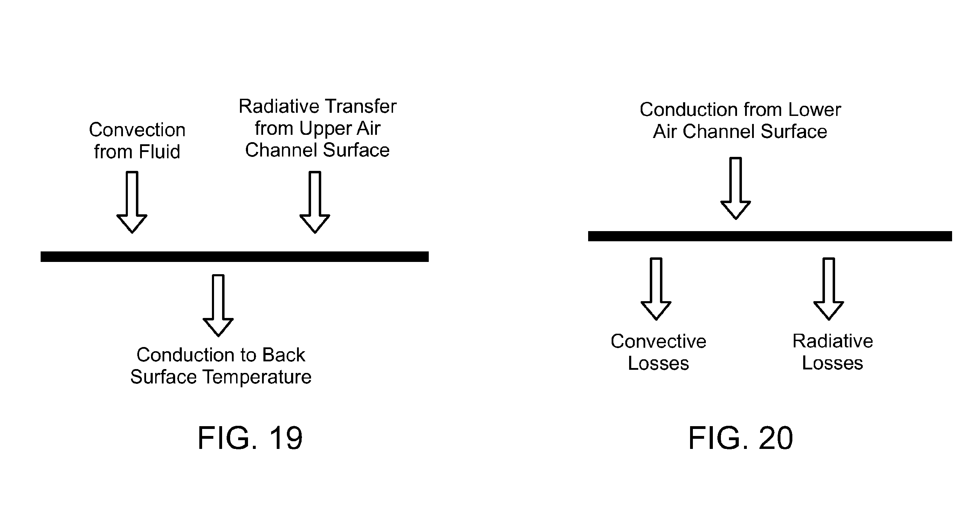

Equation 16: An energy balance on the lower air channel surface at any point along the surface shows the following relationship, as illustrated in Fig. 19:

$$q_3'' = h_{fluid}(T_1 - T_{fluid}) - h_{fluid}(T_{fluid} - T_2)$$

Equation 17:

Where equation 18:

$$h_{fluid}(T_{fluid} - T_2) + h_{rad,1\rightarrow2}(T_1 - T_2) = \frac{(T_2 - T_3)}{R_3}$$

3:    $$h_{rad,1\rightarrow2} = \frac{\sigma(T_1^2 + T_2^2)(T_1 + T_2)}{\frac{1}{\varepsilon_1} + \frac{1}{\varepsilon_2} - 1}$$

An energy balance on the back collector surface at any point along the surface is illustrated in Fig. 20.

Equation 19: and equation 20:

$$0 = \frac{(T_2 - T_3)}{R_3} - h_{conv,back}(T_3 - T_{back}) - h_{rad,back}(T_3 - T_{back,rad})$$

$$): \quad h_{rad,back} = \epsilon_{back}\,\sigma\left(T_3 + T_{back,rad}\right)\left(T_3^{\,2} + T_{back,rad}^{\,2}\right)$$

Solving the six energy balance equations (Equations 1, 4, 15, 16, 17 and 19) for the collector useful energy gain as a function of the local fluid temperature, we find:

Equation 21:

$$q''_u = T_{fluid}\left(-2h_{fluid} + \frac{R_2\,h_{fluid}^{\,2}}{m} + \frac{h_{fluid}^{\,2}}{j} + \frac{2\,R_2\,h_{fluid}^{\,2}\,h_{rad,1\to2}}{m\,j} + \frac{R_2\,h_{fluid}^{\,2}\,h_{rad,1\to2}^{\,2}}{m\,j^2}\right)$$

$$+ \frac{h_{fluid}\,h_{conv,back}\,T_{back}}{j\,H'} + \frac{h_{fluid}\,h_{rad,back}\,T_{back,rad}}{j\,H'} + \frac{h_{fluid}\,S}{G'\,m} + \frac{h_{fluid}\,h_{conv,top}\,T_{amb}}{F'\,G'\,m} + \frac{h_{fluid}\,h_{rad,top}\,T_{sky}}{F'\,G'\,m}$$

$$+ \frac{h_{fluid}\,R_2\,h_{rad,1\to2}\,h_{conv,back}\,T_{back}}{H'\,j\,m} + \frac{h_{fluid}\,R_2\,h_{rad,1\to2}\,h_{rad,back}\,T_{back,rad}}{H'\,j\,m} + \frac{h_{fluid}\,h_{rad,1\to2}\,S}{G'\,j\,m}$$

$$+ \frac{h_{fluid}\,h_{rad,1\to2}\,h_{conv,top}\,T_{amb}}{G'\,F'\,j\,m} + \frac{h_{fluid}\,h_{rad,1\to2}\,h_{rad,top}\,T_{sky}}{G'\,F'\,j\,m} + \frac{h_{fluid}\,R_2\,h_{rad,1\to2}^{\,2}\,h_{conv,back}\,T_{back}}{H'\,j^2\,m}$$

$$+ \frac{h_{fluid}\,R_2\,h_{rad,1\to2}^{\,2}\,h_{rad,back}\,T_{back,rad}}{H'\,j^2\,m}$$

Where: Equation 22: Equation 23: Equation 24:

Equation 25: Equation 26:

$$F' = h_{rad,top}R_3 + h_{conv,top}R_3 + 1$$

$$G' = \frac{1}{R_1} + \frac{1}{R_2} + \frac{1}{R_3\,F'}$$

$$H' = 1 + R_3\,h_{conv,back} + R_3\,h_{rad,back}$$

$$j = h_{fluid} + h_{rad,1\to2} + \frac{1}{R_3} - \frac{1}{H'R_3}$$

$$m = 1 - \frac{1}{R_2\,G'} + R_2\,h_{fluid} + R_2\,h_{rad,1\to2} - \frac{R_2\,h_{rad,1\to2}^2}{j}$$

Note that the above formulation assumes that the convection coefficients from the air to the upper and lower surfaces of the air channel are identical.

The fluid convection correlations are based on the Reynolds number of the fluid flowing through the flow channel:

Equation 27:

$$Re = \frac{4\,\dot{m}}{\pi\,D_h\,\mu}$$

where the hydraulic diameter is calculated as the cross-sectional area of the flow channel divided by the perimeter of the flow channel.

If the Reynolds number is zero (no flow through the channel), the Nusselt number is based on a natural convection heat transfer correlation (all temperature in degrees Kelvin):

Equation 28:

$$Nu = 1 + 1.44\left[1 - \frac{1708\left(\sin^{1.6}(1.8\,Slope)\right)}{Ra\,\cos(Slope)}\right] * Max\left[0,\left(1 - \frac{1708}{Ra\,\cos(Slope)}\right)\right]$$
$$+ Max\left[0,\left(\left(\frac{Ra\,\cos(Slope)}{5830}\right)^{\frac{1}{3}} - 1\right)\right]$$

Where equation

$$Ra = Max\left[1,\left(\frac{g\,\Delta T_{plates}\,Spacing^3}{\overline{T}_{plates}\,\upsilon_{fluid}\,\alpha_{fluid}}\right)\right]$$ 29,

Equation 30:

$$\alpha_{fluid} = \frac{k_{fluid}}{\rho_{fluid}\,Cp_{fluid}}$$

If the flow through the channel is laminar (Reynolds number < 2300) then a constant surface temperature heat transfer correlation is utilized:

Equation 31:

$$Nu = 3.66$$

If the flow through the channel is turbulent (Reynolds number > 2300) then the Dittus Boelter heat transfer correlation is utilized:

Equation 32:

$$Nu = 0.023 \, Re^{0.8} \, Pr^{n}$$

The exponent in Equation 32 (n) is set to 0.4 for heating (plates warmer than the fluid) and to

0.3 for cooling (plates cooler than the fluid).

The fluid convection coefficient can then be calculated from knowledge of the Nusselt number:

Equation 33 : An energy balance taken around a differential section of fluid moving through the collector (in the ydirection) can be written as:

$$h_{fluid} = \frac{Nu \, k_{fluid}}{D_h}$$

Equation 34: Subbing equation 21 into equation 34 we find:

$$\dot{m} C_p \frac{dT_{fluid}}{dy} - W q_s'' = 0$$

$$\frac{dT_{fluid}}{dy} = \left( \frac{W}{\dot{m} C_p} \right) a \, T_{fluid} + \left( \frac{W}{\dot{m} C_p} \right) b$$

Where equation 36 and equation 37:

$$a = \left( -2 h_{fluid} + \frac{R_2 \, h_{fluid}^2}{m} + \frac{h_{fluid}^2}{j} + \frac{2 R_2 \, h_{fluid}^2 \, h_{rad,1 \to 2}}{m \, j} + \frac{R_2 \, h_{fluid}^2 \, h_{rad,1 \to 2}^2}{m \, j^2} \right)$$

$$b = \frac{h_{fluid} \, h_{conv,back} T_{back}}{j \, H'} + \frac{h_{fluid} \, h_{rad,back} T_{back,rad}}{j \, H'} + \frac{h_{fluid} \, S}{G' \, m} + \frac{h_{fluid} \, h_{conv,top} T_{amb}}{F' \, G' \, m} + \frac{h_{fluid} \, h_{rad,top} T_{sky}}{F' \, G' \, m}$$
$$+ \frac{h_{fluid} \, R_2 \, h_{rad,1 \to 2} \, h_{conv,back} T_{back}}{H' \, j \, m} + \frac{h_{fluid} \, R_2 \, h_{rad,1 \to 2} \, h_{rad,back} T_{back,rad}}{H' \, j \, m} + \frac{h_{fluid} \, h_{rad,1 \to 2} \, S}{G' \, j \, m}$$
$$+ \frac{h_{fluid} \, h_{rad,1 \to 2} \, h_{conv,top} T_{amb}}{G' \, F' \, j \, m} + \frac{h_{fluid} \, h_{rad,1 \to 2} \, h_{rad,top} T_{sky}}{G' \, F' \, j \, m} + \frac{h_{fluid} \, R_2 \, h_{rad,1 \to 2}^2 \, h_{conv,back} T_{back}}{H' \, j^2 \, m}$$
$$+ \frac{h_{fluid} \, R_2 \, h_{rad,1 \to 2}^2 \, h_{rad,back} T_{back,rad}}{H' \, j^2 \, m}$$

$$b = \frac{h_{fluid} \, h_{conv,back} T_{back}}{j \, H'} + \frac{h_{fluid} \, h_{rad,back} T_{back,rad}}{j \, H'} + \frac{h_{fluid} \, S}{G' \, m} + \frac{h_{fluid} \, h_{conv,top} T_{amb}}{F' \, G' \, m} + \frac{h_{fluid} \, h_{rad,top} T_{sky}}{F' \, G' \, m}$$

$$+ \frac{h_{fluid} \, R_2 \, h_{rad,1 \to 2} \, h_{conv,back} T_{back}}{H' \, j \, m} + \frac{h_{fluid} \, R_2 \, h_{rad,1 \to 2} \, h_{rad,back} T_{back,rad}}{H' \, j \, m} + \frac{h_{fluid} \, h_{rad,1 \to 2} \, S}{G' \, j \, m}$$

$$+ \frac{h_{fluid} \, h_{rad,1 \to 2} \, h_{conv,top} T_{amb}}{G' \, F' \, j \, m} + \frac{h_{fluid} \, h_{rad,1 \to 2} \, h_{rad,top} T_{sky}}{G' \, F' \, j \, m} + \frac{h_{fluid} \, R_2 \, h_{rad,1 \to 2}{}^2 \, h_{conv,back} T_{back}}{H' \, j^2 \, m}$$

$$+ \frac{h_{fluid} \, R_2 \, h_{rad,1 \to 2}{}^2 \, h_{rad,back} T_{back,rad}}{H' \, j^2 \, m}$$

If we assume that a and b are independent of position in the collector along the ydirection, we can integrate equation 35 from zero to y and find the local temperature solution:

$$T_{fluid}(y) = \left( T_{fluid,in} + \frac{b}{a} \right) \exp\left( \frac{W}{\dot{m} \, C_p} a \, y \right) - \frac{b}{a}$$

If we let y = L, the collector outlet temperature can be calculated as:

$$T_{fluid,out} = \left( T_{fluid,in} + \frac{b}{a} \right) \exp\left( -\frac{Area \; a}{\dot{m} \, C_p} \right) - \frac{b}{a}$$

The mean fluid temperature can be found by integrating the fluid temperature with respect to y and dividing by the flow length (equation 6.9.1 of Duffie and Beckman):

Equation 40:

Using equation 38 and 40 and solving the differential equation we find:

$$\overline{T}_{fluid} = \frac{1}{L} \int_0^L T_{fluid}(y) \, dy$$

$$\overline{T}_{fluid} = \left( \frac{T_{fluid,in} + \dfrac{b}{a}}{\dfrac{Area \; a}{\dot{m} \, C_p}} \right) \exp\left( \frac{Area \; a}{\dot{m} \, C_p} \right) - \left( \frac{T_{fluid,in} + \dfrac{b}{a}}{\dfrac{Area \; a}{\dot{m} \, C_p}} \right) - \frac{b}{a}$$

Using equation 39, and knowing the collector fluid inlet temperature, we can find the collector useful energy gain as:

$$\text{Equation 42:}$$

$$Q_u = \dot{m}\, C_p \left( T_{fluid,out} - T_{fluid,in} \right)$$

Using the six energy balance equations on the various collector surfaces (Equations 1, 4, 15, 16, 17 and 19), we can derive an expression for the upper air channel mean surface temperature as a function of the mean fluid temperature and other known quantities: Using the six energy balance equations on the various collector surfaces (Equations 1, 4, 15, 16, 17 and 19), we can derive an expression for the lower air channel mean surface temperature as a function of the upper air channel mean surface temperature, the mean fluid temperature, and other known quantities:

$$\overline{T_1} = \frac{S}{m\,G'} + \frac{h_{conv,top}T_{amb}}{m\,G'\,F'} + \frac{h_{rad,top}T_{sky}}{m\,G'\,F'} + \frac{R_2\,h_{fluid}\overline{T}_{fluid}}{m} + \frac{R_2\,h_{rad,1\to2}\,h_{fluid}\overline{T}_{fluid}}{m\,j}$$
$$+ \frac{R_2\,h_{rad,1\to2}\,h_{conv,back}T_{back}}{m\,j\,H'} + \frac{R_2\,h_{rad,1\to2}\,h_{rad,back}T_{back,rad}}{m\,j\,H'}$$

$$\overline{T_2} = \frac{h_{rad,1\to2}\overline{T_1}}{j} + \frac{h_{fluid}\overline{T}_{fluid}}{j} + \frac{h_{conv,back}T_{back}}{j\,H'} + \frac{h_{rad,back}T_{back,rad}}{j\,H'}$$

Again using the six energy balance equations on the various collector surfaces, we can derive an expression for the collector back surface temperature as a function of the lower air channel mean surface temperature and other known quantities:

$$\overline{T_3} = \frac{\overline{T_2}}{H'} + \frac{R_3\,h_{conv,back}T_{back}}{H'} + \frac{R_3\,h_{rad,back}T_{back,rad}}{H'}$$

Using the same approach we can derive an expression for the PV temperature (absorbing surface) as a function of known variables:

$$\overline{T}_{PV} = \frac{S}{G'} + \frac{h_{conv,top}T_{amb}}{G'\,F'} + \frac{h_{rad,top}T_{sky}}{G'\,F'} + \frac{\overline{T_1}}{G'\,R_2}$$

Finally we can derive an expression for the cover surface temperature as a function of known variables:

$$\overline{T}_{Cover} = \frac{\overline{T}_{PV}}{F'} + \frac{R_1\,h_{conv,top}T_{amb}}{F'} + \frac{R_1\,h_{rad,top}T_{sky}}{F'}$$

However, the solution to this set of equations requires an iterative approach as S is a function of the PV temperature (and hence the fluid temperature), the radiation heat transfer coefficients are functions of the surface temperatures, and the fluid convection coefficient is also temperature dependent. The iterative approach is summarized below:

1. 1. Guess values for the mean fluid temperature, mean PV cell temperature, mean back surface temperature, mean cover temperature, and mean air channel surface temperatures.
2. 2. Calculate the radiation heat transfer coefficients using equations 2, 18, and 20.
3. 3. Calculate the PV cell efficiency and S using equations 9 through 14.
4. 4. Calculate the fluid heat transfer coefficient using equations 27 through 33.
5. 5. Calculate the fluid outlet temperature using equation 39 and the mean fluid temperature using equation 41.
6. 6. Calculate the mean surface temperatures using equations 43 through 47.
7. 7. Repeat steps 2 to 6 until convergence is reached

The remaining relevant heat transfers for the collector are then calculated as: Equation 48:

Equation 49:

Equation 50: Equation 51: Equation 52: Equation 53: With these definitions in place, an energy balance around the collector can be written as:

$$Q_{loss,top,conv} = h_{conv,top} \, Area \left( \overline{T}_{Cover} - T_{amb} \right)$$

$$Q_{loss,top,rad} = h_{rad,top} \, Area \left( \overline{T}_{Cover} - T_{sky} \right)$$

$$Q_{loss,back,conv} = h_{conv,back} \, Area \left( \overline{T}_3 - T_{back} \right)$$

$$Q_{loss,back,rad} = h_{rad,top} \, Area \left( \overline{T}_3 - T_{back,rad} \right)$$

$$Q_{absorbed} = Area \, (\tau \alpha)_n \, IAM \, G_T \, (1 - \eta_{PV})$$

$$Power_{PV} = Area \, (\tau \alpha)_n \, IAM \, G_T \, \eta_{PV}$$

Equation 54:

$$Q_{absorbed} + Power_{PV} = Q_u + Q_{loss,top,conv} + Q_{loss,top,rad} + Q_{loss,back,conv} + Q_{loss,back,rad}$$

**TRNSYS Component Configuration**

| PARAMETERS | | | | |
|---|---|---|---|---|
| Parameter Number | Name | Unit | Typical Value | Comment |
| 1 | Collector length | m | 1.0 | The length of the collector along the direction of the air flow through the channel. |
| | Collector width | m | 1.0 | The width of the collector across the direction of the air flow through the channel. |
| 3 | Cover emissivity | - | 0.9 | The emissivity of the cover surface for long-wave radiation exchange with the sky. |
| 4 | Thermal conductivity of cover material | KJh m.K | 5.04 | The thermal conductivity of the transparent glazing acting as a cover for the REV system. |
| 5 | Thickness of cover | m | 0.00635 | The thickness of the transparent cover material |
| 6 | Resistance of substrate maternal | h.m$^2$. K/kJ | 0.01 | The resistance to heat transfer of the material located between the absorbing PV surface and the upper flow channel surface. This resistance includes any conductive resistance of the absorber plate as well as any material between the absorber and the flow channel. |
| 7 | Emissivity — top surface of flow channel | - | 0.9 | The emissivity of the top surface of the flow channel (for radiation across the flow channel) |
| 8 | Emissivity — bottom surface of flow channel | - | 0.9 | The emissivity of the bottom surface of the flow channel (for radiation across the flow channel) |

(continued)

| PARAMETERS | | | | |
|---|---|---|---|---|
| **Parameter Number** | **Name** | **Unit** | **Typical Value** | **Comment** |
| 9 | Resistance of back material | $h.m^2 .K/kJ$ | 1.0 | The resistance to heat transfer for material(s) located between the bottom of the flow channel and the back of the collector. |
| 10 | Emissivity — back surface | - | 0.9 | The emissivity of the collector back surface for long-wave radiation exchange with the zone. |
| 11 | Channel height | m | 0.0508 | The separation distance between the parallel plates defining the flow channel |
| 12 | IAM Mode | - | 1 | The mode defining how off-normal solar radiation effects are calculated by the model: 1= Linear IAM approach from AS HRAE 2= Calculated from cover and absorber properties |
| 13 | PV Mode | - | 1 | The mode defining how the PV efficiency should be calculated by the model: 1= Linear modifiers far off-rated cell temperature and incident radiation 2= User-provided data file of PV efficiency as a function of cell temperature and incident radiation 3=Efficiency provided as an INPUT |
| If IAM Mode = 1 (NPAR=15) | | | | |
| 14 | Transmittance-absorptance product at normal incidence | - | 0.85 | The transmittance of the cover material multiplied by the absorptance of the PV surface when the incident solar radiation is normal to the surface. |
| 15 | 1st order IAM | | 0.1 | 1st order coefficient in the IAM function ($b_0$). |
| If IAM Mode = 2 (NPAR=16) | | | | |
| 14 | Absorptance of PV surface | - | 0.9 | The absorptance of the PV surface for solar radiation. |
| 15 | Cover index of refraction | - | 1.526 | The index of refraction of the transparent cover material |
| 16 | Extinction coefficient | 1/m | 4.0 | The index of refraction of the transparent cover maternal. |
| If PV Mode = 1 | | | | |

(continued)

| PARAMETERS | | | | |
|---|---|---|---|---|
| **Parameter Number** | **Name** | **Unit** | **Typical Value** | **Comment** |
| NPAR+L | PV efficency at reference condition | - | 0.12 | The efficiency of the PV cells in converting incident radiation to electricity at the provided reference conditions. |
| NPAR+2 | PV cell reference temperature | C | 20.0 | The reference temperatures at which the efficiency of the PV cell is provided. |
| NPAR+3 | PV cell reference radiation | kJ/h.m2 | 3600.0 | The reference total incident solar radiation at which the efficiency of the PV cell is provided |
| NPAR+4 | Efficiency modifier — temperature | 1/C | -0.005 | The multiplier to correct the rated PV cell efficiency as a function of cell temperature, |
| NPAR+5 | Efficiency modifier — radiation | h.m2/KJ | 0.000025 | The multiplier to correct the rated PV cell efficiency as a function of incident solar radiation. |
| If PV Mode = 2 | | | | |
| NPAR+1 | Logical unit for data file | - | 10 | The logical unit which has been ASSIGNed to the external data file containing the PV efficiency as a function of the cell temperature and incident radiation. |
| NPAR+2 | Number of temperature points | - | 21 | The number of PV cell temperatures for which PV efficiency is provided in the external data file. |
| NPAR+3 | Number of radiation points | - | 2 | The number of incident solar radiation values for which PV efficiency is provided in the external data file |

| INPUTS | | | | |
|---|---|---|---|---|
| **Input Number** | **Name** | **Unit** | **Typical Value** | **Comment** |
| 1 | **Inlet air** temperature | C | 20.0 | The temperature of the air entering the collector at the flow inlet. |
| 2 | Inlet air flow rate | kg/hr | 200.0 | The flow rate of dry air entering the collector at the fluid inlet. |

(continued)

| INPUTS | | | | |
|---|---|---|---|---|
| Input Number | Name | Unit | Typical Value | Comment |
| 3 | Ambient temperature | C | 20.0 | The temperature of the environment for calculating losses from the top collector surface. |
| 4 | Sky temperature | C | 20.0 | The temperature of the sky for calculating long-wave radiation losses from the collector surface |
| 5 | Back-surface environment temperature | c | 20.0 | The temperature of the air located behind the back surface of the collector. This temperature is typically the zone temperature in a BIPV applications. |
| 6 | Back-surface radiant temperature | C | 20.0 | The temperature of the surfaces located behind the back surface of the collector for long-wave radiation loss calculations. For BIPV applications, this value is typically set to the wall surface temperature of the zone. |
| 7 | Incident solar radiation | kJ.hr-m$^2$ | 0.0 | The rate at which incident solar radiation (beam + diffuse) strikes the sloped collector surface. |
| 8 | Total horizontal radiation | kJ.hr-m$^2$ | 0.0 | The rate at which total solar radiation (beam + diffuse) strikes a horizontal surface- |
| 9 | Horizontal diffuse radiation | kJ.hr-m$^2$ | 0.0 | The rate at which diffuse radiation strikes a horizontal surface. |
| 10 | Ground reflectance | - | 02 | The reflectance to solar radiation of the surface upon which the collector is located. |
| 11 | Incidence angle | degrees | 0.0 | The angle of incidence between beam solar radiation and the sloped collector surface. |
| 12 | Collector slope | degrees | 45.0 | The slope of the collector surface (0=honzontal, 90=vertical facing the azimuth). |
| 13 | Top loss convection coefficient | kJ/hr-m$^2$-K | 20.0 | The convective heat loss coefficient from the cover to the ambient (should not include radiative losses). |

(continued)

| INPUTS | | | | |
|---|---|---|---|---|
| **Input Number** | **Name** | **Unit** | **Typical Value** | **Comment** |
| 14 | Back loss convention coefficient | kJ/hr-m$^2$-K | 20.0 | The connective heat loss coefficient from the back of the collector to the environment (should not include radiative losses). |
| 15 | Atmospheric pressure | Aim | 1.0 | The absolute pressure of the air stream flowing through the collector (used to evaluate the fluid properties) |
| If PV Mode = 3 | | | | |
| 16 | PV efficiency | - | 0.12 | The efficiency of the PV cells in converting incident radiation to electricity at the current timestep. |

| OUTPUTS | | | |
|---|---|---|---|
| **Output Number** | **Name** | **Unit** | **Comment** |
| 1 | Outlet air temperature | C | The temperature of the air exiting the collector- |
| 2 | Outlet air flow rate | kg/hr | The flow rate of dry air exiting the collector. |
| 3 | Useful energy gain | kJ/hr | The net rate at which energy is transferred to the fluid flowing through the solar collector. |
| 4 | Thermal efficiency | - | The efficiency off the solar collector in converting incident solar radiation to delivered fluid energy. |
| 5 | Electrical powder | kJ/hr | The rate at which the PV cells are producing electrical power |
| 6 | Electrical efficiency | - | efficiency of the PV cells in converting incident solar radiation to electrical energy. |
| 7 | Cover temperature | C | The mean surface temperature of the cover |
| 8 | PV cell temperature | C | The mean temperature of the absorbing PV surface. |
| 9 | Upper air channel surface temperature | C | The mean temperature of the upper air channel surface. |
| 10 | Mean fluid temperature | C | The mean temperature of the fluid in the solar collector. |
| 11 | Lower air channel surface temperature | C | The mean temperature of the lower air channel surface. |
| 12 | Back surface temperature | C | The mean temperature of the back surface of the collector (zone air/collector back interface). |
| 13 | Overall IAM | - | The overall (beam plus diffuse) Incidence angle modifier for the collector. |

(continued)

| OUTPUTS | | | |
|---|---|---|---|
| **Output Number** | **Name** | **Unit** | **Comment** |
| 14 | Top losses - convective | kJ/hr | The rate at which energy is lost to the environment through convection from the cover surface to the ambient. |
| 15 | Top losses - radiative | kJ/hr | The rate at which energy is lost to the environment through radiation exchange from the cover surface to the sky. |
| 16 | Back losses - convective | kJ/hr | The rate at winch energy is lost to the zone through convection from the back surface to the zone air. |
| 17 | Back losses - radiative | kJ/hr | The rate at which energy is lost to the zone through radiation exchange from the back surface to the zone surfaces. |
| 18 | Absorbed solar radiation | kJ/hr | The net rate at which solar radiation is absorbed by the collector This value does not include the radiation that was absorbed by the PV cells and converted to electrical energy. |

It is appreciated that certain features of the invention, which are, for clarity, described in the context of separate embodiments, may also be provided in combination in a single embodiment. Conversely, various features of the invention, which are, for brevity, described in the context of a single embodiment, may also be provided separately or in any suitable subcombination.

Although the invention has been described in conjunction with specific embodiments thereof, it is evident that many alternatives, modifications and variations will be apparent to those skilled in the art. Accordingly, it is intended to embrace all such alternatives, modifications and variations that fall within the spirit and broad scope of the appended claims. All publications, patents, and patent applications mentioned in this specification are herein incorporated in their entirety by reference into the specification, to the same extent as if each individual publication, patent or patent application was specifically and individually indicated to be incorporated herein by reference. In addition, citation or identification of any reference in this application shall not be construed as an admission that such reference is available as prior art to the present invention.

## Claims

1. A solar panel comprising:

   an array of solar cells;
   a cooling arrangement comprising cooling fins; and
   thermal glue thermally connecting said solar cells to said cooling fins.

2. The solar panel of claim 1, wherein said thermal glue comprises silicon cream or metallic particles.

3. The solar panel of claim 1 or claim 2, wherein said thermal glue contains metallic particles, and wherein said metallic particles comprise zinc, or zinc powder or zinc dust, or copper, or copper filings.

4. The solar panel of any one of the preceding claims, wherein said thermal glue provides thermal equilibrium between said cooling fins and said solar cells irrespective of inexact alignment between said cooling fins and said solar cells.

5. The solar panel of any one of the preceding claims, further comprising a backing structure, for pressing said cooling arrangement against said thermal glue.

6. A composition comprising a silicon cream and metallic particles mixed therein.

7. The composition of claim 6, wherein said metallic particles comprise zinc, or zinc powder, or zinc dust, or copper, or copper filings.

8. The composition of claim 6 or claim 7, wherein said metallic particles comprise between 10% and 50% by weight of said composition.

9. The composition of claim 8, wherein said metallic particles comprise substantially 30% by weight of said composition.

10. The composition of claim 8, having a thermal conductivity of at least 0.9, or having a thermal conductivity of at least 0.99.

11. A method of manufacturing a solar panel comprising:

   providing an array of solar cells;
   providing a cooling arrangement; and
   attaching said cooling arrangement to said solar cells using thermal glue.

12. The method of claim 11, further comprising:

   providing a PV frame;
   fixing a backing behind said frame to press said cooling arrangement against said thermal glue and said array of solar cells.

13. The method of claim 11, or claim 12, wherein said cooling arrangement comprises a water or liquid cooling grill comprising fins for setting in thermal equilibrium with solar cells of said array, surfaces of said grill towards said solar cells being smeared with said thermal glue.

14. The method of claim 12 or claim 13, further comprising using aluminum support structures to tighten the cooling arrangement to the backing.

15. The method of any one of claims 11 - 14, further comprising covering the cooling structure with an isolation polymer.

**Fig. 1**

Fig. 2

FIG. 3

```
┌─────────────────────────────┐
│  Provide array of solar cells │
└─────────────────────────────┘
              │
              ▼
┌─────────────────────────────┐
│  Provide cooling arrangement │
└─────────────────────────────┘
              │
              ▼
┌─────────────────────────────┐
│   Connect with thermal glue  │
└─────────────────────────────┘
              │
              ▼
┌─────────────────────────────┐
│        Place backing         │
└─────────────────────────────┘
              │
              ▼
┌─────────────────────────────────────┐
│  Fit frame around panel to press     │
│  backing onto cooling arrangement    │
│            and array                 │
└─────────────────────────────────────┘
```

Fig. 4

PV CELL

SIDE

Water

Air

Water

Air

"SoLoR"
MuLTI SoLAR   RooF_TILE

FIG. 5

EP 2 352 179 A2

The Effect of Temperature on a Solar Cell

FIG. 6

EP 2 352 179 A2

**Temperature Coefficients of a Multicrystalline
PV Module, Measured at ECN in 1999**

(a)　TC(Voc) = -3.26 E-3

(b)　TC(Isc) = 2.08 E-4

(c)　TC(Pmp) = -4.35 E-3

(d)　TC(FF) = -1.37 E-3

FIG. 7

Incident Solar Radiation

PV Cells →

Adhesive,
Substrate etc.

Absorber
Plate

Insulation, Collector
Back Material

Flow Tubes

FIG. 8

FIG. 9

EP 2 352 179 A2

FIG. 10

FIG. 11

Conduction from
PV Surface

Conduction
from Fins

Absorber
Plate

Conduction to
Collector Back

Heat Transfer
to Fluid

FIG. 12

Incident Solar Radiation

PV Cells →

Transparent Cover ←

Backer Material ←

← Air Channel →

Insulation, Back Cover Material,
Roof Material etc.

FIG. 13

EP 2 352 179 A2

Absorbed Solar Radiation

Convective Losses

Radiative Losses

$T_{cover}$

$T_{plate}$

PV Cells

Transparent Cover

Backer Material

$T_1$

Air Channel

$T_2$

Collector Back Insulation etc.

$T_3$

Convective Losses

Radiative Losses

FIG. 14

EP 2 352 179 A2

EP 2 352 179 A2

Convective
Losses

Radiative
Losses

Conduction from
PV Cells

FIG. 15

Absorbed
Solar
Radiation

Conduction
to Cover

Power
Production

Conduction to
Upper Air-Channel
Surface

FIG. 16

Conduction from
PV Surface

Convection
to Fluid
Radiative Transfer to
Lower Air Channel
Surface

FIG. 17

Convection from Upper
Air Channel Surface

Air Flow

Convection to Lower Air
Channel Surface

FIG. 18

EP 2 352 179 A2

Convection
from Fluid

Radiative Transfer
from Upper Air
Channel Surface

Conduction to Back
Surface Temperature

FIG. 19

Conduction from Lower
Air Channel Surface

Convective
Losses

Radiative
Losses

FIG. 20